(19) **Europäisches Patentamt European Patent Office Office européen des brevets**

(11) **EP 4 711 416 A1**

(12) **EUROPEAN PATENT APPLICATION**
published in accordance with Art. 153(4) EPC

(43) Date of publication:
**18.03.2026 Bulletin 2026/12**

(21) Application number: **24806886.8**

(22) Date of filing: **04.04.2024**

(51) International Patent Classification (IPC):
*C08L 63/00* (2006.01)   *C08K 3/22* (2006.01)
*C08K 3/28* (2006.01)   *C08K 9/06* (2006.01)
*H05K 1/03* (2006.01)

(52) Cooperative Patent Classification (CPC):
**C08K 3/22; C08K 3/28; C08K 9/06; C08L 63/00; H05K 1/03**

(86) International application number:
**PCT/JP2024/013944**

(87) International publication number:
**WO 2024/236932 (21.11.2024 Gazette 2024/47)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **12.05.2023 JP 2023079474**
**01.09.2023 JP 2023142107**
**22.09.2023 JP 2023158503**
**22.09.2023 JP 2023158504**
**22.09.2023 JP 2023158505**

(71) Applicant: **TOKUYAMA CORPORATION**
**Yamaguchi 745-8648 (JP)**

(72) Inventors:
• **MASADA Isao**
**Shunan-shi, Yamaguchi 745-8648 (JP)**
• **HAMASAKA Tomomi**
**Shunan-shi, Yamaguchi 745-8648 (JP)**
• **HAMASAKA Go**
**Shunan-shi, Yamaguchi 745-8648 (JP)**

(74) Representative: **Dehns**
**10 Old Bailey**
**London EC4M 7NG (GB)**

(54) **RESIN COMPOSITION AND USE THEREOF**

(57)    The present invention relates to providing a resin composition which has high fluidity and provides a cured product having low linear expansivity and high thermal conduction property. A first resin composition of the present invention contains an epoxy resin (A), an aluminum nitride filler (B), and an alumina filler (C), in which a total amount of the aluminum nitride filler (B) and the alumina filler (C) is 800 to 1800 parts by mass with respect to 100 parts by mass of the epoxy resin (A), the epoxy resin (A) contains a solid epoxy resin (A-1) and a liquid epoxy resin (A-2), the aluminum nitride filler (B) has an average particle diameter D50 of 0.2 to 3 $\mu$m and a maximum particle diameter Dmax of 5 $\mu$m or less, and the alumina filler (C) has an average particle diameter D50 of 0.05 to 1.5 $\mu$m.

**Description**

Technical Field

The present invention relates to a resin composition and use thereof.

Background Art

With the increase in performance and miniaturization of electronic devices, wiring in multilayer printed wiring boards is becoming finer and denser. As a technique for producing a multilayer printed wiring board, a production method using a build-up method in which insulating layers and conductor layers are alternately stacked is known.

An insulating layer can be efficiently formed by using a film-like resin composition (resin composition film) for the insulating layer. As the resin composition film, it is common to use a resin composition containing a thermosetting epoxy resin and silica (Patent Literature 1). An insulating layer is generally formed by superimposing a resin composition film on a conductor layer, and thermally curing the resin composition while bringing the conductor layer and the resin composition into close contact with each other using a vacuum laminator or a hot press.

Therefore, the resin composition film is required to have high fluidity under the lamination condition in order to follow the shape of the conductor layer, and a solid epoxy resin and a liquid epoxy resin are generally used in combination as the epoxy resin.

In addition, since the linear expansivity by heat of the insulating layer and the conductor layer (copper wiring) is greatly different from each other, there is also a problem of reliability in a multilayer printed wiring board that cracks occur in a thermal cycle, for example, and the insulating layer is also required to have low linear expansion. Therefore, the resin composition film is generally highly packed with silica in order to reduce the linear expansion coefficient of the insulating layer.

As a high-density mounting method, an electronic component-embedded substrate technology in which an electronic component that has been mounted on a surface of a substrate until now is embedded inside a substrate with a sealing resin has also attracted attention. An electronic component is sealed and incorporated by forming a cavity in a core of a resin substrate and a copper substrate, placing an electronic component such as an IC or a capacitor in the cavity, and then embedding a thermosetting resin in the cavity. A resin composition film as used for the multilayer printed wiring board can also be used as the sealing resin.

A resin composition film is superimposed on a core on which an electronic component is placed, and the resin composition is embedded in a cavity by hot pressing and sealed by thermal curing (semi-additive method). Even when a resin composition is used for a component-embedded substrate, the resin composition is required to have high fluidity for embedding in a cavity, and a cured product made of the resin composition is required to have low linear expansivity.

As a higher-density mounting form, there is also used a module in which a multilayer wiring layer is formed by the semi-additive method on a surface of a component-embedded substrate with an electronic component incorporated therein, and further an electronic component is mounted on the surface.

Furthermore, in recent years, with the miniaturization and increase in performance of electronic devices, semiconductor elements are becoming denser and more highly mounted in multilayer printed wiring boards and component-embedded substrates. Along with this, the heat generation amount of a semiconductor element also increases, and it is important to efficiently dissipate the heat from the substrate.

Therefore, also in the production of a multilayer printed wiring board using a build-up method, in order to cope with such a problem, it has been proposed to use, as a resin composition film, a resin composition having a high thermal conductivity using aluminum nitride having a higher thermal conductivity than silica (Patent Literature 2). Specifically, Patent Literature 2 proposes a resin composition containing aluminum nitride or silicon nitride treated with a silane compound, an epoxy resin, and a curing agent, and discloses a resin composition showing a thermal conductivity of up to 2.8 W/m·K in examples thereof.

Citation List

Patent Literature

Patent Literature 1: JP 2011-132507 A
Patent Literature 2: WO 2014/208352 A

Summary of Invention

Technical Problem

In consideration of recent trend towards higher density and higher mounting of electronic devices, a cured product made of a resin composition is required to have a higher thermal conductivity. Further, a resin composition film used in a multilayer printed wiring board and a component-embedded substrate is required to have not only a high thermal conductivity but also high fluidity and low linear expansivity.

However, when the filling rate of the filler in the resin composition is increased in order to improve the thermal conduction property of the cured product, the fluidity of the resin composition may decrease, and the formulation of the resin and the filler is limited, and in the prior art, there is a limit in achieving high thermal conduction of the resin composition that can be used as a resin composition film used for production of a multilayer printed wiring board and a component-embedded substrate.

Therefore, an object of the present invention is to provide a resin composition which has high fluidity and provides a cured product having low linear expansivity and high thermal conduction property.

Solution to Problem

The resin composition of the present invention relates to, for example, the following [1] to [13].

[1] A resin composition containing: an epoxy resin (A); an aluminum nitride filler (B); and an alumina filler (C), in which

the aluminum nitride filler (B) and the alumina filler (C) are contained in a total amount of 800 to 1800 parts by mass with respect to 100 parts by mass of the epoxy resin (A),
the epoxy resin (A) contains a solid epoxy resin (A-1) and a liquid epoxy resin (A-2),
the aluminum nitride filler (B) has an average particle diameter D50 of 0.2 to 3 $\mu$m and a maximum particle diameter Dmax of 5 $\mu$m or less, and
the alumina filler (C) has an average particle diameter D50 of 0.05 to 1.5 $\mu$m.

[2] The resin composition according to [1], in which

the aluminum nitride filler (B) is a surface-treated aluminum nitride filler that has been subjected to a surface treatment with a silane coupling agent (SC1) having an organic reactive group containing an oxygen atom, a nitrogen atom, or a sulfur atom,
the alumina filler (C) is a surface-treated alumina filler that has been subjected to a surface treatment with a silane coupling agent (SC2) having an organic reactive group that contains an oxygen atom, a nitrogen atom, or a sulfur atom, and is different from the organic reactive group of the silane coupling agent (SC1), and
the average particle diameter D50 of the aluminum nitride filler (B) is larger than the average particle diameter D50 of the alumina filler (C).

[3] The resin composition according to [2], in which

the aluminum nitride filler (B) is a surface-treated aluminum nitride filler that has been subjected to a surface treatment with a silane coupling agent (SC1) having an organic reactive group containing a (meth)acrylic group, and
the alumina filler (C) is a surface-treated alumina filler in which an alumina filler (C0) having a product of an average particle diameter D50 ($\mu$m) and a specific surface area SA (m$^2$/g) of 2.6 or more has been subjected to a surface treatment with a silane coupling agent (SC2) having an organic reactive group that contains an amino group forming a secondary amine structure, and is different from the organic reactive group of the silane coupling agent (SC1).

[4] The resin composition according to [3], in which
a ratio (D50/L$_{104}$) of an average particle diameter D50 ($\mu$m) to a crystallite size L$_{104}$ ($\mu$m) calculated from a half width of a diffraction peak attributed to a (104) plane obtained by X-ray diffractometry in the alumina filler (C0) is 6.0 or more.
[5] The resin composition according to [3] or [4], in which
a ratio (D90/D10) of a 90% particle diameter D90 to a 10% particle diameter D10 calculated from a volume-based cumulative particle size distribution in the alumina filler (C0) is 2.3 or less.
[6] The resin composition according to [2], in which

the aluminum nitride filler (B) is a surface-treated aluminum nitride filler that has been subjected to a surface treatment with a silane coupling agent (SC1) having an organic reactive group containing an epoxy group, and the alumina filler (C) is a surface-treated alumina filler in which an alumina filler (C0) having a product of an average particle diameter D50 ($\mu$m) and a specific surface area SA (m$^2$/g) of less than 2.6 has been subjected to a surface treatment with a silane coupling agent (SC2) having an organic reactive group that contains an amino group forming a secondary amine structure, and is different from the organic reactive group of the silane coupling agent (SC1).

[7] The resin composition according to [6], in which
a ratio (D50/L$_{104}$) of an average particle diameter D50 ($\mu$m) to a crystallite size L$_{104}$ ($\mu$m) calculated from a half width of a diffraction peak attributed to a (104) plane obtained by X-ray diffractometry in the alumina filler (C0) is 6.0 or less.
[8] The resin composition according to any one of [2] to [7], in which
the silane coupling agent (SC2) has an organic reactive group containing a phenylamino group.
[9] The resin composition according to any one of [1] to [8], in which

the aluminum nitride filler (B) has a specific surface area SA of 0.5 to 10 m$^2$/g, and
the alumina filler (C) has a specific surface area SA of 1 to 50 m$^2$/g.

[10] The resin composition according to any one of [1] to [9], in which
a ratio (S2/S1) of a total surface area S1 of the aluminum nitride filler (B) to a total surface area S2 of the alumina filler (C) is 0.5 to 2.2.
[11] A resin composition film made of the resin composition according to any one of [1] to [10].
[12] A multilayer printed wiring board including the resin composition according to any one of [1] to [10] or a cured product thereof.
[13] A component-embedded substrate including the resin composition according to any one of [1] to [10] or a cured product thereof.

Advantageous Effects of Invention

The resin composition of the present invention has high fluidity and provides a cured product having low linear expansivity and high thermal conduction property. When the resin composition is shaped into a film and used, for example, a multilayer printed wiring board and a component-embedded substrate having excellent heat dissipation performance can be efficiently produced.

Description of Embodiments

Hereinafter, an example of an embodiment of the present invention will be described in detail. However, the present invention is not limited to the following embodiments, and can be arbitrarily modified and implemented without departing from the gist of the present invention.
In the present description, "(meth)acrylic" represents both or either of "acrylic" and "methacrylic".
A first resin composition of the present invention is a resin composition containing an epoxy resin (A), an aluminum nitride filler (B), and an alumina filler (C), in which

the aluminum nitride filler (B) and the alumina filler (C) are contained in a total amount of 800 to 1800 parts by mass with respect to 100 parts by mass of the epoxy resin (A),
the epoxy resin (A) contains a solid epoxy resin (A-1) and a liquid epoxy resin (A-2),
the aluminum nitride filler (B) has an average particle diameter D50 of 0.2 to 3 $\mu$m and a maximum particle diameter Dmax of 5 $\mu$m or less, and
the alumina filler (C) has an average particle diameter D50 of 0.05 to 1.5 $\mu$m.

A second resin composition of the present invention is a resin composition containing an epoxy resin (A), an aluminum nitride filler (B), and an alumina filler (C), in which

the aluminum nitride filler (B) and the alumina filler (C) are contained in a total amount of 800 to 1800 parts by mass with respect to 100 parts by mass of the epoxy resin (A),
the epoxy resin (A) contains a solid epoxy resin (A-1) and a liquid epoxy resin (A-2),
the aluminum nitride filler (B) is a surface-treated aluminum nitride filler that has been subjected to a surface treatment with a silane coupling agent (SC1) having an organic reactive group containing an oxygen atom, a nitrogen atom, or a sulfur atom, and that has an average particle diameter D50 of 0.2 to 3 $\mu$m and a maximum particle diameter Dmax of 5

μm or less,
the alumina filler (C) is a surface-treated alumina filler that has been subjected to a surface treatment with a silane coupling agent (SC2) having an organic reactive group that contains an oxygen atom, a nitrogen atom, or a sulfur atom, and is different from the organic reactive group of the silane coupling agent (SC1), and that has an average particle diameter D50 of 0.05 to 1.5 μm, and
the average particle diameter D50 of the aluminum nitride filler (B) is larger than the average particle diameter D50 of the alumina filler (C).

A third resin composition of the present invention is a resin composition containing an epoxy resin (A), an aluminum nitride filler (B), and an alumina filler (C), in which

the aluminum nitride filler (B) and the alumina filler (C) are contained in a total amount of 800 to 1800 parts by mass with respect to 100 parts by mass of the epoxy resin (A),
the epoxy resin (A) contains a solid epoxy resin (A-1) and a liquid epoxy resin (A-2),
the aluminum nitride filler (B) is a surface-treated aluminum nitride filler that has been subjected to a surface treatment with a silane coupling agent (SC1) having an organic reactive group containing a (meth)acrylic group,
the alumina filler (C) is a surface-treated alumina filler in which an alumina filler (C0) having a product of an average particle diameter D50 (μm) and a specific surface area SA ($m^2$/g) of 2.6 or more has been subjected to a surface treatment with a silane coupling agent (SC2) having an organic reactive group that contains an amino group forming a secondary amine structure, and is different from the organic reactive group of the silane coupling agent (SC1), and an average particle diameter D50 of the aluminum nitride filler (B) is larger than an average particle diameter D50 of the alumina filler (C).

A fourth resin composition of the present invention is a resin composition containing an epoxy resin (A), an aluminum nitride filler (B), and an alumina filler (C), in which

the aluminum nitride filler (B) and the alumina filler (C) are contained in a total amount of 800 to 1800 parts by mass with respect to 100 parts by mass of the epoxy resin (A),
the epoxy resin (A) contains a solid epoxy resin (A-1) and a liquid epoxy resin (A-2),
the aluminum nitride filler (B) is a surface-treated aluminum nitride filler that has been subjected to a surface treatment with a silane coupling agent (SC1) having an organic reactive group containing an epoxy group,
the alumina filler (C) is a surface-treated alumina filler in which an alumina filler (C0) having a product of an average particle diameter D50 (μm) and a specific surface area SA ($m^2$/g) of less than 2.6 has been subjected to a surface treatment with a silane coupling agent (SC2) having an organic reactive group that contains an amino group forming a secondary amine structure, and is different from the organic reactive group of the silane coupling agent (SC1), and an average particle diameter D50 of the aluminum nitride filler (B) is larger than an average particle diameter D50 of the alumina filler (C).

[Epoxy resin (A)]

The resin composition of the present invention contains an epoxy resin (A). The epoxy resin (A) preferably contains a compound containing one or more epoxy groups in the molecule (hereinafter sometimes referred to as a "reactive epoxy resin"). The reactive epoxy resin may be a low molecular weight compound having an epoxy group. The reactive epoxy resin more preferably contains two or more epoxy groups in the molecule.

The epoxy resin (A) preferably contains 50 mass% or more of the reactive epoxy resin with respect to the total amount of the epoxy resin (A). When the epoxy resin (A) contains the reactive epoxy resin, the resin composition tends to be softened and has excellent fluidity. Therefore, when the resin composition is used as a resin composition film for producing a multilayer printed wiring board or a component-embedded substrate, the resin composition easily follows the shape of a conductor layer of the multilayer printed wiring board, or a cavity and an electronic component of the component-embedded substrate. In addition, since a cured product obtained by thermal curing after the resin composition is changed into a desired shape has a high strength and heat resistance, the reliability of, for example, the substrate can be improved.

The upper limit of the content ratio of the reactive epoxy resin in the total amount of the epoxy resin (A) is not particularly limited, and all the epoxy resin (A) may be the reactive epoxy resin.

The epoxy resin (A) contains a solid epoxy resin (A-1) and a liquid epoxy resin (A-2). In the present description, an epoxy resin that is solid at a temperature of 25°C is referred to as the solid epoxy resin (A-1), and an epoxy resin that is liquid at 25°C is referred to as the liquid epoxy resin (A-2).

When the epoxy resin (A) contains the solid epoxy resin (A-1), the strength and heat resistance of a cured product obtained by thermally curing the resin composition tend to be improved. On the other hand, since the melt viscosity of the solid epoxy resin (A-1) tends to be high, when the liquid epoxy resin (A-2) having high fluidity is used in combination with the solid epoxy resin (A-1) having high heat resistance, the fluidity of the resin composition is improved, and the resin composition can follow a desired substrate shape.

The solid epoxy resin (A-1) is preferably a reactive epoxy resin.

As the solid epoxy resin (A-1), a tetrafunctional naphthalene type epoxy resin, a trifunctional naphthalene type epoxy resin, a trisphenol methane type epoxy resin, a phenol novolac type epoxy resin, a cresol novolac type epoxy resin, a bisphenol A novolac type epoxy resin, a naphthol novolac type epoxy resin, a naphthol cresol novolac type epoxy resin, a dicyclopentadiene type epoxy resin, a biphenyl aralkyl type epoxy resin, a bixylenol type epoxy resin, a naphthylene ether type epoxy resin, a biphenyl type epoxy resin, and a fluorene type epoxy resin are preferable, and a tetrafunctional naphthalene type epoxy resin, a biphenyl aralkyl type epoxy resin, a trisphenol methane type epoxy resin, a bixylenol type epoxy resin, a naphthylene ether type epoxy resin, and a fluorene type epoxy resin are more preferable.

Examples of commercially available products of the tetrafunctional naphthalene type epoxy resin include "HP-4700" and "HP-4710" manufactured by DIC Corporation.

Examples of commercially available products of the cresol novolac type epoxy resin include "N-690" and "N-695" manufactured by DIC Corporation.

Examples of commercially available products of the dicyclopentadiene type epoxy resin include "HP-7200", "HP-7200L", and "HP-7200H" manufactured by DIC Corporation.

Examples of commercially available products of the naphthylene ether type epoxy resin include "HP-6000" and "HP-6000H" manufactured by DIC Corporation.

Examples of commercially available products of the trisphenol methane type epoxy resin include "EPPN-501H", "EPPN-501HY", and "EPPN-502H" manufactured by Nippon Kayaku Co., Ltd.

Examples of commercially available products of the naphthol cresol novolac epoxy resin include "NC-7000L", "NC-7000H", and "NC-7300L" manufactured by Nippon Kayaku Co., Ltd.

Examples of commercially available products of the biphenyl aralkyl type epoxy resin include "NC-3000H", "NC-3000", "NC-3000L", "NC-3100", and "NC-3500" manufactured by Nippon Kayaku Co., Ltd.

Examples of commercially available products of the naphthol novolac type epoxy resin include "ESN475" and "ESN485" manufactured by Nippon Steel Chemical Co., Ltd.

Examples of commercially available products of the biphenyl type epoxy resin include "YX4000H" and "YL6121" manufactured by Mitsubishi Chemical Corporation.

Examples of commercially available products of the bixylenol type epoxy resin include "YX4000HK" manufactured by Mitsubishi Chemical Corporation.

Examples of commercially available products of the fluorene type epoxy resin include "YL7800" manufactured by Mitsubishi Chemical Corporation.

The softening point of the solid epoxy resin (A-1) is preferably 40 to 130°C from the viewpoint of formability of the resin composition. The softening point is more preferably 45°C or higher, still more preferably 50°C or higher, and is more preferably 110°C or lower, still more preferably 100°C or lower.

As the solid epoxy resin (A-1), one type may be used alone, or two or more types may be used.

The solid epoxy resin (A-1) may be used as a composition containing the solid epoxy resin (A-1) and an organic solvent when the resin composition is produced.

The organic solvent in the composition may be any solvent as long as it can dissolve the solid epoxy resin (A-1), and examples thereof include acetone, methanol, ethanol, butanol, 2-propanol, 2-methoxyethanol, 2-ethoxyethanol, 1-methoxy-2-propanol, 2-acetoxy-1-methoxypropane, toluene, xylene, methyl ethyl ketone, N,N-dimethylformamide, methyl isobutyl ketone, N-methyl-pyrrolidone, n-hexane, cyclohexane, cyclohexanone, and solvent naphtha which is a mixture thereof, and methyl ethyl ketone is preferable.

The boiling point of the organic solvent is preferably 200°C or lower, and more preferably 180°C or lower from the viewpoint of ease of removal of the organic solvent.

As the organic solvent, one type may be used alone, or two or more types may be used.

The content of a nonvolatile component in the composition is preferably 20 to 90 mass%, more preferably 30 to 80 mass%, and still more preferably 40 to 70 mass% from the viewpoint of dissolving the solid epoxy resin (A-1) in an organic solvent.

In the present description, the nonvolatile component refers to all components excluding the solvent.

The content of the organic solvent in the composition is preferably 10 to 80 mass%, more preferably 20 to 70 mass%, and still more preferably 30 to 60 mass%.

The composition may contain a component other than the epoxy resin (A), the aluminum nitride filler (B), and the alumina filler (C) which may be contained in the resin composition.

When the epoxy resin (A) contains the liquid epoxy resin (A-2), the melt viscosity of the resin composition can be kept at a low level, and the resin composition tends to have excellent fluidity. Therefore, in order to be used for a multilayer printed wiring board and a component-embedded substrate, when a film made of the resin composition is shaped under heat and pressure, the film made of the resin composition is excellent in followability to the shapes of a conductor layer and a cavity.

The liquid epoxy resin (A-2) is preferably a reactive epoxy resin.

As the liquid epoxy resin (A-2), a bisphenol A type epoxy resin, a bisphenol F type epoxy resin, a phenol novolac type epoxy resin, and a naphthalene type epoxy resin are preferable, and a bisphenol A type epoxy resin and a bisphenol F type epoxy resin are more preferable.

Examples of commercially available products of the bisphenol A type epoxy resin include "jER 828", "jER 828EL", and "jER 828US" manufactured by Mitsubishi Chemical Corporation.

Examples of commercially available products of the bisphenol F type epoxy resin include "jER 806", "jER 806H", and "jER 807" manufactured by Mitsubishi Chemical Corporation, and "YDF-8170C" manufactured by Nippon Steel Chemical & Materials Co., Ltd.

Examples of commercially available products of the phenol novolac type epoxy resin include "jER 152" manufactured by Mitsubishi Chemical Corporation.

Examples of commercially available products of a mixed product of a bisphenol A type epoxy resin and a bisphenol F type epoxy resin include "ZX1059" manufactured by Nippon Steel Chemical & Materials Co., Ltd.

Examples of commercially available products of the naphthalene type epoxy resin include "HP 4032", "HP 4032D", and "HP 4032SS" manufactured by DIC Corporation.

As the liquid epoxy resin (A-2), one type may be used alone, or two or more types may be used.

The viscosity of the liquid epoxy resin (A-2) at 25°C is preferably 500 poise or less, more preferably 300 poise or less, still more preferably 200 poise or less, and is preferably 5 poise or more, more preferably 10 poise or more.

When the viscosity of the liquid epoxy resin (A-2) at 25°C is within the above range, the melt viscosity of the resin composition can be kept at a low level, and the resin composition tends to have excellent fluidity.

The ratio of the contents of the solid epoxy resin (A-1) and the liquid epoxy resin (A-2) (solid epoxy resin : liquid epoxy resin) is preferably in a range of 9 : 1 to 1 : 9, more preferably 4 : 1 to 1 : 4, still more preferably 3 : 1 to 1 : 3, and particularly preferably 2 : 1 to 1 : 2 in mass ratio. When the ratio of the contents of the solid epoxy resin (A-1) and the liquid epoxy resin (A-2) is within the above range, both high fluidity of the resin composition and high heat resistance of the cured product can be achieved.

The epoxy equivalent of the epoxy resin (A) is preferably 50 to 4500, and more preferably 50 to 3000. The epoxy equivalent is still more preferably 80 or more, particularly preferably 100 or more, and is still more preferably 2000 or less, particularly preferably 1000 or less. When the epoxy equivalent of the epoxy resin (A) is within the above range, a cured product obtained by curing the resin composition is excellent in crosslinking density, and tends to have sufficient heat resistance and mechanical strength when the resin composition is used as a film.

The epoxy equivalent can be measured according to JIS K 7236. The epoxy equivalent is the mass of a resin per equivalent of epoxy group.

[Aluminum nitride filler (B)]

The resin composition contains an aluminum nitride filler (B). When the resin composition contains the aluminum nitride filler (B), a cured product made of the resin composition can have high thermal conduction property.

The average particle diameter D50 of the aluminum nitride filler (B) is 0.2 to 3 $\mu$m. The average particle diameter D50 is preferably 0.3 $\mu$m or more, more preferably 0.5 $\mu$m or more, and is preferably 2 $\mu$m or less, more preferably 1.5 $\mu$m or less. When the average particle diameter D50 of the aluminum nitride filler (B) is in the above range, the resin composition is easily shaped into a film having a thickness of about several micrometers to several hundreds micrometers, and a cured product made of the film having a thickness in the above range tends to have high thermal conduction property.

The average particle diameter D50 in the present invention is a particle diameter at a cumulative 50% value on a volume basis in a particle size distribution measured by a laser diffraction scattering method. The particle size distribution can be measured by the method described in the section of Examples below.

The maximum particle diameter Dmax of the aluminum nitride filler (B) is 5 $\mu$m or less, preferably 4.5 $\mu$m or less, and more preferably 4 $\mu$m or less. When the maximum particle diameter Dmax of the aluminum nitride filler (B) is in the above range, the melt viscosity of the resin composition tends to decrease. Therefore, in order to be used for a multilayer printed wiring board and a component-embedded substrate, when a film made of the resin composition is shaped under heat and pressure, the film made of the resin composition is excellent in followability to the shapes of a conductor layer and a cavity.

The maximum particle diameter Dmax in the present invention is the maximum value (cumulative volume 100% particle diameter) of the measured particle diameter in the particle size distribution measured by a laser diffraction scattering method. The particle size distribution can be measured by the method described in the section of Examples below.

The specific surface area SA of the aluminum nitride filler (B) is preferably 0.5 to 10 $m^2/g$. The specific surface area SA is more preferably 0.8 $m^2/g$ or more, still more preferably 1.0 $m^2/g$ or more, and is more preferably 7 $m^2/g$ or less, still more preferably 5 $m^2/g$ or less. When the specific surface area SA of the aluminum nitride filler (B) is in the above range, the aluminum nitride filler (B) is excellent in dispersibility in the epoxy resin (A), and the melt viscosity of the resin composition tends to decrease.

The specific surface area SA in the present invention can be measured by a BET method using a flow-type specific surface area automatic measuring apparatus. The specific surface area SA can be measured by the method described in the section of Examples below.

The aluminum nitride filler (B) may be an aluminum nitride filler that has not been subjected to a surface treatment with a surface treatment agent, or an aluminum nitride filler that has been subjected to a surface treatment with a surface treatment agent.

Examples of commercially available products of the aluminum nitride filler that has not been subjected to a surface treatment with a surface treatment agent include an aluminum nitride filler HF-01D (manufactured by Tokuyama Corporation). As the aluminum nitride filler, a commercially available aluminum nitride powder may be used after the particle size distribution is adjusted using, for example, a sieve or a classifier.

A method for producing the aluminum nitride filler that has not been subjected to a surface treatment with a surface treatment agent is not particularly limited, and an aluminum nitride filler produced by a known method can be used. Examples of the method for producing the aluminum nitride filler include a direct nitriding method, a reduction nitriding method, and a gas-phase synthesis method.

The aluminum nitride filler (B) may be an aluminum nitride filler that has been subjected to a surface treatment with a surface treatment agent. By performing the surface treatment with the surface treatment agent, the water resistance of the aluminum nitride filler is improved, and the affinity for the epoxy resin (A) is improved. Therefore, the filling property of the aluminum nitride filler is improved, and the fluidity of the resin composition is easily improved.

Examples of the surface treatment agent include a silane compound such as a silane coupling agent, an aluminate coupling agent, and a titanate coupling agent. The surface treatment agent is preferably a silane compound from the viewpoint of being able to increase the reaction rate between the surface treatment agent and the aluminum nitride filler.

Examples of the silane compound used as the surface treatment agent include a silane compound having a reactive functional group and a silane compound having a non-reactive functional group.

Examples of the silane compound having a reactive functional group include alkoxysilanes such as 3-glycidoxypropyl trimethoxysilane, 3-glycidoxypropyl triethoxysilane, 3-glycidoxypropyl methyl dimethoxysilane, 3-glycidoxypropyl methyl diethoxysilane, 2-(3,4-epoxy cyclohexyl) ethyl trimethoxysilane, 3-methacryloxypropyl trimethoxysilane, 3-methacryloxypropyl triethoxysilane, 3-methacryloxypropyl methyl dimethoxysilane, 3-methacryloxypropyl methyl diethoxysilane, 3-acryloxypropyl trimethoxysilane, 3-mercaptopropyl trimethoxysilane, 3-aminopropyl trimethoxysilane, 3-aminopropyl triethoxysilane, 2-aminoethyl-3-aminopropyl trimethoxysilane, 2-aminoethyl-3-aminopropyl methyl dimethoxysilane, 3-dimethyl aminopropyl trimethoxysilane, 3-diethyl aminopropyl trimethoxysilane, 3-triethoxysilyl-N-(1,3-dimethyl-butylidene) propyl amine, N-phenyl-3-aminopropyl trimethoxysilane, vinyl trimethoxysilane, vinyl triethoxysilane, p-styryl trimethoxysilane, and allyl trimethoxysilane.

Examples of the silane compound having a non-reactive functional group include methyl trimethoxysilane, dimethyl dimethoxysilane, dimethyl diethoxysilane, trimethyl methoxysilane, ethyl trimethoxysilane, n-propyl trimethoxysilane, isobutyl trimethoxysilane, isobutyl triethoxysilane, n-hexyl trimethoxysilane, n-hexyl triethoxysilane, cyclohexyl trimethoxysilane, cyclohexyl methyl dimethoxysilane, n-octyl triethoxysilane, phenyl trimethoxysilane, phenyl triethoxysilane, diphenyl dimethoxysilane, diphenyl diethoxysilane, trifluoropropyl trimethoxysilane, and trifluoropropyl methyl dimethoxysilane.

Examples of the silane compound that can be used as the surface treatment agent include, in addition to the above compounds, chlorosilanes such as vinyl trichlorosilane, methyl trichlorosilane, dimethyl dichlorosilane, trichloromethyl silane, ethyl dimethyl chlorosilane, propyl dimethyl chlorosilane, phenyl trichlorosilane, trifluoropropyl trichlorosilane, and isopropyl diethyl chlorosilane.

Among the silane compounds, those having high affinity for the epoxy resin (A) are preferable, and examples of a silane compound having high affinity include a silane compound having a functional group capable of reacting with an epoxy group, such as a glycidoxy group and an amino group. In addition, functional groups such as a methacryloxy group, an acryloxy group, a phenyl group, a vinyl group, and a styryl group have low reactivity with an epoxy group but have high affinity for an epoxy resin, and thus, a silane compound having such a functional group is also preferable.

Among the silane compounds, the surface treatment agent is preferably a silane coupling agent having an organic reactive group containing an oxygen atom, a nitrogen atom, or a sulfur atom. That is, the aluminum nitride filler (B) is preferably an aluminum nitride filler that has been subjected to a surface treatment with a silane coupling agent (SC1) having an organic reactive group containing an oxygen atom, a nitrogen atom, or a sulfur atom.

The aluminum nitride filler that has not been subjected to a surface treatment with a silane coupling agent is also

8

referred to as "untreated aluminum nitride filler", and the aluminum nitride filler that has been subjected to a surface treatment with a silane coupling agent (SC1) is also referred to as "surface-treated aluminum nitride filler".

The aluminum nitride filler before being subjected to a surface treatment with the silane coupling agent (SC1) is usually not subjected to a surface treatment with a silane coupling agent.

The untreated aluminum nitride filler is acceptable unless it has not been subjected to a surface treatment with a silane coupling agent, and may be subjected to, for example, a water resistance treatment of oxidizing the surface of the filler.

The silane coupling agent (SC1) is a silane compound having a hydrolyzable group and an organic reactive group containing an oxygen atom, a nitrogen atom, or a sulfur atom, and is preferably an alkoxysilane compound having an organic reactive group containing an oxygen atom, a nitrogen atom, or a sulfur atom.

The hydrolyzable group is directly bonded to a silicon atom. Examples of the hydrolyzable group include alkoxy groups such as a methoxy group and an ethoxy group.

The organic reactive group containing an oxygen atom, a nitrogen atom, or a sulfur atom refers to a substituent other than a hydrolyzable group bonded to a silicon atom ,and that contains a reactive functional group containing an oxygen atom, a nitrogen atom, or a sulfur atom.

The reactive functional group containing an oxygen atom, a nitrogen atom, or a sulfur atom is preferably bonded to a silicon atom via a linear, branched, or cyclic alkylene group having 1 to 10 carbon atoms.

Examples of the reactive functional group containing an oxygen atom include a hydroxy group, a carbonyl group, and an ether group bonded to two carbon atoms (-C-O-C- bond). The ether group bonded to two carbon atoms may be a cyclic ether group.

The reactive functional group containing an oxygen atom is preferably an epoxy group or a (meth)acrylic group.

Examples of the reactive functional group containing a nitrogen atom include an amino group represented by $-NR^1R^2$, a cyano group, a pyrrolidinyl group, and an isocyanate group.

$R^1$ and $R^2$ each independently represent a hydrogen atom, an alkyl group, or an aryl group. The number of carbon atoms in the alkyl group represented by $R^1$ and $R^2$ is preferably 1 to 30, more preferably 1 to 20, and still more preferably 1 to 10. The alkyl group may be linear, branched, or cyclic. The number of carbon atoms in the aryl group represented by $R^1$ and $R^2$ is preferably 6 to 30, more preferably 6 to 20, and still more preferably 6 to 10.

As the reactive functional group containing a nitrogen atom, an amino group forming a secondary amine structure is preferable, and a methylamino group and a phenylamino group are more preferable.

Examples of the reactive functional group containing a sulfur atom include a mercapto group, a sulfide group, a sulfo group, and a sulfonyl group.

As the reactive functional group containing a sulfur atom, a mercapto group is preferable.

The silane coupling agent (SC1) may have only one organic reactive group or two or more organic reactive groups.

The organic reactive group may include, for example, a reactive functional group containing an oxygen atom and a reactive functional group containing a nitrogen atom.

Examples of the silane coupling agent (SC1) include 2-((3-(triethoxysilyl)propyl)carbamoyl)benzoic acid, triethoxysilylpropylmaleamic acid, 2-((3-(trimethoxysilyl)propyl)carbamoyl)benzoic acid, trimethoxysilylpropylmaleamic acid, 3-glycidoxypropyl trimethoxysilane, 3-glycidoxypropyl triethoxysilane, 3-glycidoxypropyl methyl dimethoxysilane, 3-glycidoxypropyl methyl diethoxysilane, 2-(3,4-epoxycyclohexyl) ethyl trimethoxysilane, 3-methacryloxypropyl trimethoxysilane, 3-methacryloxypropyl triethoxysilane, 3-methacryloxypropyl methyl dimethoxysilane, 3-methacryloxypropyl methyl diethoxysilane, 3-acryloxypropyl trimethoxysilane, 3-mercaptopropyl trimethoxysilane, 3-aminopropyl trimethoxysilane, 3-aminopropyl triethoxysilane, 2-aminoethyl-3-aminopropyl trimethoxysilane, 2-aminoethyl-3-aminopropyl methyl dimethoxysilane, 3-dimethyl aminopropyl trimethoxysilane, 3-diethyl aminopropyl trimethoxysilane, 3-triethoxysilyl-N-(1,3-dimethyl-butylidene) propylamine, N-phenyl-3-aminopropyl trimethoxysilane, N-(vinylbenzyl)-2-aminoethyl-3-aminopropyltrimethoxysilane hydrochloride, tris-(trimethoxysilylpropyl)isocyanurate, 3-ureidopropyltriethoxysilane, 3-mercaptopropylmethyldimethoxysilane, and 3-(methylamino)propyltrimethoxysilane.

When the silane coupling agent (SC2) described later has an organic reactive group containing an amino group forming a secondary amine structure, the silane coupling agent (SC1) preferably does not have an organic reactive group containing an amino group forming a secondary amine structure.

The amount of the surface treatment agent used when the surface treatment is applied to the aluminum nitride filler with the surface treatment agent is preferably 0.1 to 5 parts by mass, and more preferably 0.5 to 4 parts by mass with respect to 100 parts by mass of the aluminum nitride filler before being subjected to the surface treatment.

As a method of the surface treatment with the surface treatment agent, a known method can be adopted, and either a dry surface treatment or a wet surface treatment may be employed.

The dry surface treatment is a method in which the aluminum nitride filler before being subjected to the surface treatment and the surface treatment agent are mixed by dry mixing without a large amount of a solvent. Examples of the dry surface treatment include a method of gasifying the surface treatment agent and mixing the surface treatment agent with the aluminum nitride filler before being subjected to the surface treatment, a method of spraying or dropping the surface treatment agent in a liquid state and mixing the surface treatment agent with the aluminum nitride filler before being subjected to the surface treatment, and a method of diluting the surface treatment agent with a small amount of an organic solvent to increase the liquid amount, and further spraying or dropping the surface treatment agent.

The wet surface treatment is a method in which a solvent is used when the aluminum nitride filler before being subjected to the surface treatment is mixed with the surface treatment agent. Examples of the wet surface treatment include a method in which the aluminum nitride filler before being subjected to the surface treatment, the surface treatment agent and a solvent are mixed, and then the solvent is removed by, for example, drying.

The aluminum nitride filler (B) may contain impurities derived from a raw material or impurities such as an alkaline earth element and a rare earth element intentionally added in a synthesis method in an amount of about 5 parts by mass with respect to 100 parts by mass of the aluminum nitride filler (B) as an upper limit. An impurity amount that significantly lowers the crystallinity of aluminum nitride is not preferable because it causes a decrease in thermal conduction property of a cured product made of the resin composition.

The aluminum nitride content in the aluminum nitride filler (B) is preferably 95 mass% or more, and more preferably 99 mass% or more.

As the aluminum nitride filler (B), one type may be used or two or more types may be used.

[Alumina filler (C)]

The resin composition contains an alumina filler (C).

The alumina filler (C) has an average particle diameter D50 of 0.05 to 1.5 $\mu$m. The average particle diameter D50 is preferably 0.1 $\mu$m or more, more preferably 0.15 $\mu$m or more, and is preferably 1.0 $\mu$m or less, more preferably 0.8 $\mu$m or less. The average particle diameter D50 of the aluminum nitride filler (B) is preferably larger than the average particle diameter D50 of the alumina filler (C). When the average particle diameter D50 of the aluminum nitride filler (B) is larger than the average particle diameter D50 of the alumina filler (C), the alumina filler (C) enters gaps between the aluminum nitride fillers (B) in the resin composition, and therefore even when the filling rate of the aluminum nitride filler (B) and the alumina filler (C) is increased, the fluidity of the resin composition tends not to excessively decrease. In addition, since the contact area of the thermally conductive particles increases, the thermal conduction property of a cured product made of the resin composition tends to be improved. Furthermore, when the average particle diameter D50 of the alumina filler (C) is in the above range, the resin composition is easily shaped into a film having a thickness of about several micrometers to several hundreds micrometers, and a cured product made of the film having a thickness in the above range tends to have high thermal conduction property.

The ratio of the average particle diameter D50 of the alumina filler (C) to the average particle diameter D50 of the aluminum nitride filler (B) (average particle diameter D50 of alumina filler (C)/average particle diameter D50 of aluminum nitride filler (B)) is preferably 0.02 to 0.9. The ratio is more preferably 0.05 or more, still more preferably 0.10 or more, and is more preferably 0.8 or less, still more preferably 0.7 or less. When the ratio of the average particle diameter D50 is within the above range, the aluminum nitride filler (B) and the alumina filler (C) are excellent in filling property in the resin composition, and the melt viscosity of the resin composition tends to decrease.

The maximum particle diameter Dmax of the alumina filler (C) is preferably 5 $\mu$m or less, more preferably 4 $\mu$m or less, and still more preferably 3 $\mu$m or less.

The specific surface area SA of the alumina filler (C) is preferably 1 to 50 m$^2$/g. The specific surface area SA is more preferably 1.5 m$^2$/g or more, still more preferably 2 m$^2$/g or more, and is more preferably 30 m$^2$/g or less, still more preferably 20 m$^2$/g or less. The alumina filler (C) having a specific surface area SA in the above range has excellent dispersibility in the resin composition, and the melt viscosity of the resin composition tends to decrease.

It is preferable that the crystallinity of the alumina filler (C) is as high as possible, and it is more preferable that in the crystal system, the proportion of the alpha crystal is as high as possible. As the crystallinity of the alumina filler (C) is higher, the thermal conduction property of a cured product made of the resin composition tends to be improved. The crystallinity of the alumina filler (C) can be checked by X-ray diffractometry.

The alumina filler (C) may be an alumina filler that has not been subjected to a surface treatment with a surface treatment agent, or may be an alumina filler that has been subjected to a surface treatment with a surface treatment agent. The surface treatment with the surface treatment agent can be performed by a known method, and may be performed by either a dry surface treatment or a wet surface treatment.

Examples of the surface treatment agent include a silane compound such as a silane coupling agent, an aluminate coupling agent, and a titanate coupling agent. Examples of the silane compound include same compounds as the silane compound that can be used for the surface treatment of the aluminum nitride filler (B). The surface treatment agent is preferably a silane compound, and more preferably a silane coupling agent.

The amount of the surface treatment agent used when the surface treatment is performed with the surface treatment agent is preferably 0.1 to 5 parts by mass, and more preferably 0.5 to 4 parts by mass with respect to 100 parts by mass of the alumina filler before being subjected to the surface treatment.

The alumina filler that has not been subjected to a surface treatment with a silane coupling agent is also referred to as "untreated alumina filler".

Examples of commercially available products of the untreated alumina filler include Advanced Alumina AA-03F (manufactured by Sumitomo Chemical Company, Limited), Advanced Alumina AA-04 (manufactured by Sumitomo Chemical Company, Limited), NXA-150 (manufactured by Sumitomo Chemical Company, Limited), Spherical Alumina ASFP-20 (manufactured by Denka Company Limited), and AHPA-0.5AF (manufactured by Sasol Ltd.).

The alumina filler that has not been subjected to a surface treatment with a silane coupling agent is also referred to as "alumina filler (C0)".

The 10% particle diameter $D10$ of the alumina filler (C0) is preferably 0.02 to 1.0 $\mu$m. The $D10$ is more preferably 0.05 $\mu$m or more, still more preferably 0.1 $\mu$m or more, and is more preferably 0.9 $\mu$m or less, still more preferably 0.7 $\mu$m or less.

The average particle diameter $D50$ of the alumina filler (C0) is preferably 0.05 to 1.5 $\mu$m. The $D50$ is more preferably 0.1 $\mu$m or more, still more preferably 0.15 $\mu$m or more, and is more preferably 1.0 $\mu$m or less, still more preferably 0.8 $\mu$m or less.

The 90% particle diameter $D90$ of the alumina filler (C0) is preferably 0.1 to 2.0 $\mu$m. The $D90$ is more preferably 0.2 $\mu$m or more, still more preferably 0.3 $\mu$m or more, and is more preferably 1.5 $\mu$m or less, still more preferably 1.0 $\mu$m or less.

The 10% particle diameter $D10$ in the present invention is a particle diameter at a cumulative 10% value on a volume basis in a particle size distribution measured by a laser diffraction scattering method. The 90% particle diameter $D90$ in the present invention is a particle diameter at a cumulative 90% value on a volume basis in a particle size distribution measured by a laser diffraction scattering method. The particle size distribution can be measured by the method described in the section of Examples below.

The specific surface area SA of the alumina filler (C0) is preferably 1 to 50 m$^2$/g. The specific surface area SA is more preferably 1.5 m$^2$/g or more, still more preferably 2 m$^2$/g or more, and is more preferably 30 m$^2$/g or less, still more preferably 20 m$^2$/g or less.

<Second resin composition>

In the second resin composition, the aluminum nitride filler (B) is an aluminum nitride filler that has been subjected to a surface treatment with a silane coupling agent (SC1) having an organic reactive group containing an oxygen atom, a nitrogen atom, or a sulfur atom, and the alumina filler (C) is an alumina filler that has been subjected to a surface treatment with a silane coupling agent (SC2) having an organic reactive group containing an oxygen atom, a nitrogen atom, or a sulfur atom.

The organic reactive group of the silane coupling agent (SC2) is different from the organic reactive group of the silane coupling agent (SC1). That is, the silane coupling agent (SC2) is a silane coupling agent having an organic reactive group that contains an oxygen atom, a nitrogen atom, or a sulfur atom, and is different from the organic reactive group of the silane coupling agent (SC1).

The second resin composition tends to have excellent dispersibility of the aluminum nitride filler (B) and the alumina filler (C) and high fluidity of the resin composition as compared with the first resin composition. A cured product made of the second resin composition tends to have high thermal conduction property as compared with a cured product made of the first resin composition.

The alumina filler that has been subjected to a surface treatment with the silane coupling agent (SC2) is also referred to as "surface-treated alumina filler".

The alumina filler before being subjected to a surface treatment with the silane coupling agent (SC2) is usually not subjected to a surface treatment with a silane coupling agent.

Examples of the silane coupling agent (SC2) include same silane coupling agents as the silane coupling agent (SC1).

The silane coupling agent (SC2) is preferably a silane coupling agent having an organic reactive group containing an oxygen atom or a nitrogen atom, more preferably a silane coupling agent having an organic reactive group containing an epoxy group, a (meth)acrylic group, or an amino group forming a secondary amine structure, and still more preferably a silane coupling agent having an organic reactive group containing a (meth)acrylic group, a methylamino group, or a phenylamino group.

Conventionally, in order to improve the thermal conduction property of a cured product made of a resin composition and the fluidity of a resin composition, for example, it has been considered to adjust, for example, the particle size distribution of a filler, but when, for example, the particle size distribution of a filler is adjusted, the dispersibility of the filler may decrease, and appearance defects may occur in a resin composition film. In order to improve the appearance defects, it is necessary to perform additional kneading using, for example, a three-roll mill when the resin composition is produced. When the dispersibility of the filler is low, production steps may increase, and therefore it is desirable that the filler to be used in the resin composition film has high dispersibility from the viewpoint of, for example, equipment, work man-hours, and production cost.

The second resin composition is excellent in dispersibility of the aluminum nitride filler (B) and the alumina filler (C). The reason for the excellent dispersibility is considered as follows.

In the second resin composition, the alumina filler (C) having a small particle diameter has a large specific surface area, and greatly affects the interaction between the filler and the epoxy resin (A). In the second resin composition, the alumina filler (C) has been subjected to a surface treatment with the silane coupling agent (SC2) having an organic reactive group containing an oxygen atom, a nitrogen atom, or a sulfur atom, and the affinity between the alumina filler (C) and the epoxy resin (A) is improved, so that it is presumed that the dispersibility of the filler in the resin composition is improved.

The dispersibility of the filler is related not only to the interaction between the epoxy resin (A) and the filler but also to the interaction between the fillers. When the untreated aluminum nitride filler and the untreated alumina filler are subjected to a surface treatment with silane coupling agents having the same organic reactive group, the dispersibility of the filler may deteriorate due to the interaction between the silane coupling agents. On the other hand, when the untreated aluminum nitride filler and the untreated alumina filler are subjected to a surface treatment with silane coupling agents each having a different organic reactive group, the interaction between the silane coupling agents in the aluminum nitride filler (B) and the alumina filler (C) can be alleviated. As a result, it is presumed that the filling property of the filler can be improved to decrease the melt viscosity of the resin composition, and the adhesion between the epoxy resin (A) and the filler can be enhanced to improve the thermal conduction property of a cured product made of the resin composition.

The combination of the silane coupling agent (SC1) and the silane coupling agent (SC2) in the second resin composition is preferably a combination in which the silane coupling agent (SC1) has an organic reactive group containing at least one type of reactive functional group selected from the group consisting of a (meth)acrylic group, a phenylamino group, and an epoxy group, and the silane coupling agent (SC2) has an organic reactive group containing at least one type of reactive functional group selected from the group consisting of a (meth)acrylic group, a phenylamino group, and a methylamino group (provided that a combination in which the organic reactive groups in the silane coupling agent (SC1) and the silane coupling agent (SC2) contain a (meth)acrylic group, a phenylamino group, a methylamino group, or an epoxy group in common is excluded), and more preferably

a combination in which the silane coupling agent (SC1) has a methacrylic group and the silane coupling agent (SC2) has a phenylamino group,
a combination in which the silane coupling agent (SC1) has a phenylamino group and the silane coupling agent (SC2) has a methacrylic group,
a combination in which the silane coupling agent (SC1) has an acrylic group and the silane coupling agent (SC2) has a phenylamino group,
a combination in which the silane coupling agent (SC1) has an epoxy group and the silane coupling agent (SC2) has a phenylamino group,
a combination in which the silane coupling agent (SC1) has an epoxy group and the silane coupling agent (SC2) has a methacrylic group, or
a combination in which the silane coupling agent (SC1) has a methacrylic group and the silane coupling agent (SC2) has a methylamino group.

<Third resin composition>

In the third resin composition, the aluminum nitride filler (B) is an aluminum nitride filler that has been subjected to a surface treatment with a silane coupling agent (SC1) having an organic reactive group containing a (meth)acrylic group, and the alumina filler (C) is an alumina filler in which an alumina filler (C0) having a product of an average particle diameter D50 ($\mu$m) and a specific surface area SA ($m^2$/g) of 2.6 or more has been subjected to a surface treatment with a silane coupling agent (SC2) having an organic reactive group that contains an amino group forming a secondary amine structure, and is different from the organic reactive group of the silane coupling agent (SC1).

The third resin composition tends to have particularly high fluidity as compared with the first resin composition.

The crystallite size $L_{104}$ of the alumina filler (C0) used in the third resin composition is preferably 20 to 120 nm. The $L_{104}$ is more preferably 30 nm or more, still more preferably 40 nm or more, particularly preferably 50 nm or more, and is more preferably 100 nm or less, still more preferably 80 nm or less, particularly preferably 68 nm or less.

The crystallite size $L_{104}$ in the present invention is calculated based on the half width of the diffraction peak attributed to the (104) plane obtained by X-ray diffractometry using the method described in the section of Examples described later.

The product of the average particle diameter D50 ($\mu$m) and the specific surface area SA ($m^2$/g) of the alumina filler (C0) used in the third resin composition is preferably 2.6 or more, more preferably 2.7 or more, still more preferably 2.8 or more, and is preferably 10 or less.

The ratio (D50/$L_{104}$) of the average particle diameter D50 ($\mu$m) to the crystallite size $L_{104}$ (um) of the alumina filler (C0) used in the third resin composition is preferably 6.0 or more, more preferably 6.2 or more, and still more preferably 6.4 or more. The upper limit of D50/$L_{104}$ is not particularly limited, but is generally 20 or less.

The ratio (D90/D10) of the 90% particle diameter D90 to the 10% particle diameter D10 of the alumina filler (C0) used in the third resin composition is preferably 2.3 or less, more preferably 2.1 or less, and still more preferably 2.0 or less. The lower limit value of D90/D10 is not particularly limited as long as it is 1 or more which is the theoretical minimum value.

Examples of commercially available products of the alumina filler (C0) having physical property values in the above range include AHPA-0.5AF (manufactured by Sasol Ltd.).

The reason why the third resin composition has high fluidity is considered as follows.

It is presumed that the alumina filler (C0) in which the product of the average particle diameter D50 and the specific surface area SA is within the above range has a large specific surface area with respect to the particle diameter and has many irregularities on the filler surface as compared with other alumina fillers. Therefore, it is presumed that the alumina filler (C) also has many irregularities on the surface, and the interaction between the alumina fillers (C) is alleviated, so that the alumina filler (C) is less likely to aggregate.

When the alumina filler (C) is a surface-treated alumina filler that has been subjected to a surface treatment with the silane coupling agent (SC2) containing an amino group forming a secondary amine structure, the alumina filler (C) is even less likely to aggregate due to the interaction between the silane coupling agents (SC2), and the affinity between the alumina filler (C) and the epoxy resin (A) is improved.

For these reasons, it is presumed that the dispersibility and filling property of the filler are improved, and the fluidity of the third resin composition is improved. The filling rate of the filler can be increased by improving the filling property of the filler, the thermal conduction property of a cured product made of the third resin composition is improved, and the linear expansivity decreases.

The large specific surface area with respect to the particle diameter in the alumina filler (C0) is presumably due to the fact that the crystallites constituting the filler particles are small in size, and D50/$L_{104}$ is in the above range.

When the specific surface area with respect to the particle diameter is large in the alumina filler (C0), the particle size distribution of the alumina filler (C0) tends to be narrow, and D90/D10 tends to fall within the above range. It is preferable that the particle size distribution of the alumina filler (C0) is narrow and D90/D10 is in the above range in addition to the large specific surface area with respect to the particle diameter in the alumina filler (C0), because the dispersibility and filling property of the filler are further improved.

In the third resin composition, when the alumina filler (C0) is subjected to a surface treatment with a silane coupling agent containing an amino group forming a primary amine structure, the reactivity between the epoxy resin (A) and the alumina filler becomes excessively high, and the alumina filler may easily aggregate.

In the third resin composition, when the alumina filler (C0) is subjected to a surface treatment with a silane coupling agent containing an amino group forming a tertiary amine structure, the reactivity between the epoxy resin (A) and the alumina filler decreases, and the filling property of the filler in the resin composition may not be improved.

In the third resin composition, it is presumed that when the untreated aluminum nitride filler and the alumina filler (C0) are subjected to a surface treatment with silane coupling agents each having a different organic reactive group, the interaction between the silane coupling agents in the aluminum nitride filler (B) and the alumina filler (C) can be alleviated, and as a result, the filling property of the filler can be improved and the fluidity of the third resin composition can be improved.

\<Fourth resin composition\>

In the fourth resin composition, the aluminum nitride filler (B) is an aluminum nitride filler that has been subjected to a surface treatment with a silane coupling agent (SC1) having an organic reactive group containing an epoxy group, and the alumina filler (C) is an alumina filler in which an alumina filler (C0) having a product of an average particle diameter D50 ($\mu$m) and a specific surface area SA ($m^2$/g) of less than 2.6 has been subjected to a surface treatment with a silane coupling agent (SC2) having an organic reactive group that contains an amino group forming a secondary amine structure, and is different from the organic reactive group of the silane coupling agent (SC1).

A cured product made of the fourth resin composition tends to have particularly high thermal conduction property as compared with a cured product made of the first resin composition.

The crystallite size $L_{104}$ of the alumina filler (C0) used in the fourth resin composition is preferably 30 to 150 nm. The $L_{104}$ is more preferably 40 nm or more, still more preferably 60 nm or more, particularly preferably 70 nm or more, and is more preferably 120 nm or less, still more preferably 100 nm or less, particularly preferably 90 nm or less.

The product of the average particle diameter D50 ($\mu$m) and the specific surface area SA ($m^2$/g) of the alumina filler (C0) used in the fourth resin composition is preferably less than 2.6, more preferably 2.3 or less, still more preferably 2.0 or less, and is preferably 1.0 or more.

The ratio (D50/$L_{104}$) of the average particle diameter D50 ($\mu$m) to the crystallite size $L_{104}$ (um) of the alumina filler (C0) used in the fourth resin composition is preferably 6.0 or less, more preferably 5.5 or less, still more preferably 5.0 or less, and is preferably 1.0 or more.

The ratio (D90/D10) of the 90% particle diameter D90 to the 10% particle diameter D10 of the alumina filler (C0) used in the fourth resin composition is preferably 8.0 or less, more preferably 6.0 or less, and still more preferably 4.0 or less. The lower limit value of D90/D10 is not particularly limited as long as it is 1 or more which is the theoretical minimum value.

Examples of commercially available products of the alumina filler (C0) having physical property values in the above range include Advanced Alumina AA-03F (manufactured by Sumitomo Chemical Company, Limited), Advanced Alumina AA-04 (manufactured by Sumitomo Chemical Company, Limited), and NXA-150 (manufactured by Sumitomo Chemical Company, Limited).

The reason why a cured product made of the fourth resin composition has high thermal conduction property is considered as follows.

It is presumed that the alumina filler (C0) in which the product of the average particle diameter D50 and the specific surface area SA is in the above range has a smooth surface as compared with other alumina fillers. Therefore, the surface of the alumina filler (C) is smooth, and the contact area between the alumina fillers (C) increases, so that heat conduction can be easily achieved. The smooth surface of the alumina filler (C0) is presumably due to the fact that the crystallite size with respect to the particle diameter is large, and D50/$L_{104}$ is in the above range. When such an alumina filler (C0) is subjected to a surface treatment with the silane coupling agent (SC2) having an organic reactive group containing an amino group forming a secondary amine structure, it is presumed that the interaction between the alumina filler (C) and the epoxy resin (A) and the interaction between the amino group derived from the silane coupling agent (SC2) in the alumina filler (C) and the epoxy group derived from the silane coupling agent (SC1) in the aluminum nitride filler (B) improve the adhesion between the alumina filler (C) and the epoxy resin (A) and the adhesion between the alumina filler (C) and the aluminum nitride filler (B), and a thermal conduction path is efficiently formed while the interfacial thermal resistance between the filler and the resin is reduced, so that the thermal conduction property is improved.

In addition, in the fourth resin composition, it is presumed that the improvement of the adhesion between the aluminum nitride filler (B) and the resin due to the interaction between the epoxy group derived from the silane coupling agent (SC1) in the aluminum nitride filler (B) and a curing agent to be described later also contributes to the improvement of the thermal conduction property by reducing the interfacial thermal resistance between the filler and the resin.

<Silane coupling agent (SC2) in third resin composition and fourth resin composition>

The amino group forming a secondary amine structure is preferably a methylamino group or a phenylamino group, and more preferably a phenylamino group. That is, the silane coupling agent (SC2) having an organic reactive group containing an amino group forming a secondary amine structure preferably has an organic reactive group containing a methylamino group or a phenylamino group, and more preferably has an organic reactive group containing a phenylamino group.

Examples of the silane coupling agent (SC2) having an organic reactive group containing an amino group forming a secondary amine structure include N-phenyl-3-aminopropyltrimethoxysilane and 3-(methylamino)propyltrimethoxysilane.

When the silane coupling agent (SC1) has an organic reactive group containing a (meth)acrylic group, the silane coupling agent (SC2) preferably does not have an organic reactive group containing a (meth)acrylic group. When the silane coupling agent (SC1) has an organic reactive group containing an epoxy group, the silane coupling agent (SC2) preferably does not have an organic reactive group containing an epoxy group.

[Content of each component]

The resin composition contains the aluminum nitride filler (B) and the alumina filler (C) in a total amount of 800 to 1800 parts by mass with respect to 100 parts by mass of the epoxy resin (A). The total content of the aluminum nitride filler (B) and the alumina filler (C) with respect to 100 parts by mass of the epoxy resin (A) is preferably 900 parts by mass or more, more preferably 1000 parts by mass or more, still more preferably 1100 parts by mass or more, and is preferably 1600 parts by mass or less, more preferably 1500 parts by mass or less, still more preferably 1400 parts by mass or less, particularly preferably 1300 parts by mass or less.

When the total content of the aluminum nitride filler (B) and the alumina filler (C) in the resin composition is within the above range, the fluidity of the resin composition, the low linear expansivity of a cured product made of the resin composition, and the high thermal conduction property of the cured product can be improved in a well-balanced manner. When the total content of the aluminum nitride filler (B) and the alumina filler (C) in the resin composition is in the above range, the dispersibility and filling property of the filler in the resin composition are also excellent.

The mass ratio of the contents of the aluminum nitride filler (B) and the alumina filler (C) (the content of the aluminum nitride filler (B)/the content of the alumina filler (C)) is preferably 95/5 to 20/80, more preferably 93/7 to 30/70, and still more preferably 90/10 to 40/60 from the viewpoint of dispersibility of the filler.

In the first resin composition, the second resin composition, and the fourth resin composition, the content ratio of the aluminum nitride filler (B) to the alumina filler (C) is preferably such that the ratio (S2/S1) of the total surface area S1 of the aluminum nitride filler (B) to the total surface area S2 of the alumina filler (C) is 0.5 to 2.2. The ratio (S2/S1) is preferably 0.8 or more, more preferably 1.0 or more, still more preferably 1.1 or more, and is preferably 2.1 or less, more preferably 1.8 or less, still more preferably 1.5 or less. By setting the value of S2/S1 within the above range, the thermal conductivity of a cured product made of the resin composition can be further increased. The reason for this is not clear, but it is presumed that the well-balanced interaction between the epoxy resin (A) and each filler improves the adhesion between the epoxy resin (A) and the filler interface and improves the filling property of the filler.

The total surface area S1 of the aluminum nitride filler (B) can be calculated by the product of the specific surface area SA of the aluminum nitride filler (B) and the content of the aluminum nitride filler (B).

The total surface area S2 of the alumina filler (C) can be calculated by the product of the specific surface area SA of the alumina filler (C) and the content of the alumina filler (C).

As the alumina filler (C), one type may be used or two or more types may be used.

[Optional component]

The resin composition may contain a component other than the epoxy resin (A), the aluminum nitride filler (B), and the alumina filler (C) (hereinafter also referred to as "optional component") as long as the effects of the present invention are not impaired. Examples of the optional component include a curing agent, a curing accelerator, a resin other than the epoxy resin (A), a filler other than the aluminum nitride filler (B) and the alumina filler (C), a flame retardant, rubber particles, a thickener, an antifoaming agent, a leveling agent, an adhesion imparting agent, an antioxidant, an ultraviolet degradation inhibitor, and a colorant.

Examples of the curing agent include an epoxy resin curing agent.

When the epoxy resin (A) contains a reactive epoxy resin, the epoxy resin curing agent has a function of curing by reacting with the reactive epoxy resin. When the resin composition contains an epoxy resin curing agent, a cured product obtained by thermally curing the resin composition tends to have a high strength and heat resistance.

As the epoxy resin curing agent, a known curing agent can be used. Examples of the epoxy resin curing agent include a phenol-based curing agent, a naphthol-based curing agent, an active ester-based curing agent, a cyanate ester-based curing agent, a benzoxazine-based curing agent, and an acid anhydride-based curing agent, and a phenol-based curing agent, a naphthol-based curing agent, and an active ester-based curing agent are preferable from the viewpoint of, for example, formability of the resin composition into a film, and heat resistance of a cured product made of the resin composition.

As the curing agent, one type may be used alone, or two or more types may be used.

As the phenol-based curing agent and the naphthol-based curing agent, a phenol-based curing agent and a naphthol-based curing agent having a novolac structure are preferable from the viewpoint of heat resistance and water resistance of a cured product made of the resin composition.

As the phenol-based curing agent having a novolac structure, phenol novolac, cresol novolac, bisphenol A type novolac, phenol aralkyl novolac, biphenyl aralkyl novolac, aminotriazine novolac (triazine structure-containing phenol novolac), triphenylmethane novolac, and cyclopentadiene phenol novolac are preferable.

As the naphthol-based curing agent having a novolac structure, naphthol aralkyl type phenol novolac, aralkyl type naphthol phenol novolac, and naphthol cresol type novolac are preferable.

Examples of commercially available products of the phenol-based curing agent and the naphthol-based curing agent include "GPH-103". "GPH-65", and "TKG-105" manufactured by Nippon Kayaku Co., Ltd., "TD-2093", "TD-2090", "LF-6161", "LF-4871", "LA-7052", "LA-7054", "LA-1536", and "LA-1356" manufactured by DIC Corporation, "ZX-798" and "SN485" manufactured by Nippon Steel Chemical & Materials Co., Ltd., "TPM-100" and "GPNX" manufactured by Gun Ei Chemical Industry Co., Ltd., and "S-TPM" and "J-DDP" manufactured by JFE Chemical Corporation.

The reactive group equivalents (hydroxy equivalents) of the phenol-based curing agent and the naphthol-based curing agent are preferably 20 to 4000, more preferably 50 to 2000, and still more preferably 50 to 1000 from the viewpoint of formability of the resin composition into a film and the heat resistance of a cured product made of the resin composition. The hydroxy equivalent is the mass of a resin per equivalent of hydroxy group.

Examples of the active ester-based curing agent include an active ester-based curing agent having a dicyclopentadiene structure, an active ester-based curing agent having a naphthalene structure, an active ester-based curing agent containing an acetylated product of phenol novolac, and an active ester-based curing agent containing a benzoylated product of phenol novolac, and from the viewpoint of heat resistance and water resistance of a cured product made of the resin composition, an active ester-based curing agent having a dicyclopentadiene structure and an active ester-based curing agent having a naphthalene structure are preferable.

Examples of commercially available products of the active ester-based curing agent having a dicyclopentadiene structure include "HPC-8000-65T" manufactured by DIC Corporation.

Examples of commercially available products of the active ester-based curing agent having a naphthalene structure include "HPC-8150-62T" manufactured by DIC Corporation.

The reactive group equivalent (active ester group equivalent) of the active ester-based curing agent is preferably 50 to 2000, more preferably 50 to 1000, and still more preferably 100 to 500 from the viewpoint of, for example, formability of the resin composition into a film and the heat resistance of a cured product made of the resin composition. The active ester group equivalent is the mass of a resin per equivalent of active ester group.

The content of the curing agent in the resin composition is preferably 50 to 200 parts by mass, more preferably 65 to 150 parts by mass, and still more preferably 75 to 125 parts by mass with respect to 100 parts by mass of the epoxy resin (A) from the viewpoint of heat resistance and mechanical strength of a cured product made of the resin composition.

The total number of reactive groups such as hydroxy groups and active ester groups in the curing agent is preferably 0.5 to 2, more preferably 0.6 to 1.5, and still more preferably 0.65 to 1.25 with respect to the total number of epoxy groups in the epoxy resin (A). The total number of epoxy groups in the epoxy resin (A) is a value obtained by dividing the mass of each epoxy resin by the epoxy equivalent and summing the values for all epoxy resins, and similarly, the total number of reactive groups in the curing agent is a value obtained by summing the values obtained by dividing the mass of each curing agent by the reactive group equivalent.

Examples of the curing accelerator include an epoxy resin curing accelerator.

The epoxy resin curing accelerator has a function of accelerating the reaction between the epoxy group of the epoxy resin (A) and the reactive group of the curing agent and the polymerization of the epoxy group. When the epoxy resin (A) contains a reactive epoxy resin, due to the incorporation of the epoxy resin curing accelerator in the resin composition, the resin composition can be easily thermally cured, and the cured product tends to have a high strength.

The content of the epoxy resin curing accelerator in the resin composition is preferably 0.01 to 5 parts by mass, more preferably 0.05 to 3 parts by mass, and still more preferably 0.1 to 2 parts by mass with respect to 100 parts by mass of the epoxy resin (A).

As the epoxy resin curing accelerator, a known epoxy resin curing accelerator can be used without particular limitation, and examples thereof include an amine-based curing accelerator, an imidazole-based curing accelerator, a phosphorus-based curing accelerator, and a guanidine-based curing accelerator, and an amine-based curing accelerator and an imidazole-based curing accelerator are preferable.

As the curing accelerator, one type may be used alone, or two or more types may be used in combination.

Examples of the amine-based curing accelerator include trialkylamines such as triethylamine and tributylamine, 4-dimethylaminopyridine, benzyldimethylamine, 2,4,6-tris(dimethylaminomethyl)phenol, and 1,8-diazabicyclo(5,4,0)-undecene.

Examples of the imidazole-based curing accelerator include imidazole compounds such as 2-methylimidazole, 2-undecylimidazole, 2-heptadecylimidazole, 1,2-dimethylimidazole, 2-ethyl-4-methylimidazole, 1,2-dimethylimidazole, 2-ethyl-4-methylimidazole, 2-phenylimidazole, 2-phenyl-4-methylimidazole, 1-benzyl-2-methylimidazole, 1-benzyl-2-phenylimidazole, 1-cyanoethyl-2-methylimidazole, 1-cyanoethyl-2-undecylimidazole, 1-cyanoethyl-2-ethyl-4-methylimidazole, 1-cyanoethyl-2-phenylimidazole, 1-cyanoethyl-2-undecylimidazolium trimellitate, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'-methylimidazolyl-(1')]-ethyl-s-triazine, 2,4-diamino-6-[2'-methylimidazolyl-(1')]-ethyl-s-triazine isocyanuric acid adduct, 2-phenylimidazole isocyanuric acid adduct, 2-phenyl-4,5-dihydroxymethylimidazole, 2-phenyl-4-methyl-5-hydroxymethylimidazole, 2,3-dihydro-1H-pyrrolo[1,2-a]benzimidazole, 1-dodecyl-2-methyl-3-benzylimidazolium chloride, 2-methylimidazoline, and 2-phenylimidazoline, and an adduct of an imidazole compound with an epoxy resin.

Examples of the phosphorus-based curing accelerator include triphenylphosphine, a phosphonium borate compound, tetraphenylphosphonium tetraphenylborate, n-butylphosphonium tetraphenylborate, tetrabutylphosphonium decanoate, (4-methylphenyl)triphenylphosphonium thiocyanate, tetraphenylphosphonium thiocyanate, and butyltriphenylphosphonium thiocyanate.

Examples of the guanidine-based curing accelerator include dicyandiamide, 1-methylguanidine, 1-ethylguanidine, 1-cyclohexylguanidine, 1-phenylguanidine, 1-(o-tolyl)guanidine, dimethylguanidine, diphenylguanidine, trimethylguanidine, tetramethylguanidine, pentamethylguanidine, 1,5,7-triazabicyclo[4.4.0]dec-5-ene, 7-methyl-1,5,7-triazabicyclo[4.4.0]dec-5-ene, 1-methylbiguanide, 1-ethylbiguanide, 1-n-butylbiguanide, 1-n-octadecylbiguanide, 1,1-dimethylbiguanide, 1,1-diethylbiguanide, 1-cyclohexylbiguanide, 1-allylbiguanide, 1-phenylbiguanide, and 1-(o-tolyl)biguanide.

When the resin composition contains a resin other than the epoxy resin (A) (hereinafter also referred to as "optional resin"), the resin composition tends to have, for example, excellent flexibility. Therefore, when a film is shaped from the resin composition, applicability is improved to obtain a uniform film, or the film becomes flexible to improve windability. In addition, for example, the impact resistance of a cured product made of the resin composition is improved, and the cured product is less likely to crack.

Examples of the optional resin include thermoplastic resins such as a phenoxy resin, a polyvinyl acetal resin, a polyolefin resin, a polybutadiene resin, a polyimide resin, a polyamideimide resin, a polyethersulfone resin, a polyphenylene ether resin, and a polysulfone resin, and among these, a phenoxy resin having a structure similar to that of the epoxy resin (A) is preferable because compatibility with the epoxy resin (A) is good.

As the optional resin, one type may be used alone, or two or more types may be used.

Examples of the phenoxy resin include phenoxy resins having one or more types of skeletons selected from the group consisting of a bisphenol A skeleton, a bisphenol F skeleton, a bisphenol S skeleton, a bisphenol acetophenone skeleton, a novolac skeleton, a biphenyl skeleton, a fluorene skeleton, a dicyclopentadiene skeleton, a norbornene skeleton, a naphthalene skeleton, an anthracene skeleton, an adamantane skeleton, a terpene skeleton, and a trimethylcyclohexane skeleton.

The terminal of the phenoxy resin may have any terminal structure such as a phenolic hydroxy group or an epoxy group.

As the phenoxy resin, one type may be used alone, or two or more types may be used.

Examples of commercially available products of the bisphenol acetophenone skeleton-containing phenoxy resin include "YX6954BH30" manufactured by Mitsubishi Chemical Corporation.

Examples of commercially available products of the bisphenol S skeleton-containing phenoxy resin include "YX8100BH30" manufactured by Mitsubishi Chemical Corporation.

Examples of commercially available products of the phenoxy resin further include "YX7553BH30" manufactured by Mitsubishi Chemical Corporation.

The weight average molecular weight of the phenoxy resin is preferably 5000 to 10000. The weight average molecular weight of the phenoxy resin is a weight average molecular weight in terms of polystyrene measured by gel permeation chromatography.

The content of the optional resin such as a phenoxy resin in the resin composition is preferably 0.1 to 50 parts by mass, more preferably 0.5 to 30 parts by mass, and still more preferably 1 to 20 parts by mass with respect to 100 parts by mass of the epoxy resin (A).

A filler other than the aluminum nitride filler (B) and the alumina filler (C) (hereinafter also referred to as "optional filler") is a filler including a material other than aluminum nitride and alumina. The optional filler may contain, for example, silica, zinc oxide, magnesium oxide, titanium oxide, silicon nitride, boron nitride, aluminum hydroxide, magnesium hydroxide, silicon carbide, calcium carbonate, barium sulfate, talc, or diamond.

The content of the optional filler in the resin composition is preferably 10 parts by mass or less, more preferably 5 parts by mass or less, still more preferably 1 part by mass or less with respect to 100 parts by mass of the total amount of the aluminum nitride filler (B) and the alumina filler (C), and particularly preferably, the resin composition does not contain the optional filler.

The average particle diameter D50 of the optional filler is preferably smaller than the average particle diameter D50 of the aluminum nitride filler (B), more preferably less than 2 $\mu$m, and still more preferably less than 1.5 $\mu$m.

The maximum particle diameter Dmax of the optional filler is preferably smaller than the maximum particle diameter Dmax of the aluminum nitride filler (B), more preferably less than 4.5 $\mu$m, and still more preferably less than 4 $\mu$m.

The flame retardant imparts flame retardancy when the resin composition is used for a semiconductor product. Examples of the flame retardant include an organic phosphorus-based flame retardant, an organic nitrogen-containing phosphorus compound, a nitrogen compound, a silicone-based flame retardant, and a metal hydroxide.

As the flame retardant, one type may be used alone, or two or more types may be used.

When the resin composition contains rubber particles, the internal stress when the resin composition is thermally cured is relaxed, and the warpage of the cured product is reduced, so that the cured product tends to have excellent impact resistance.

Examples of the rubber particles include fine particles such as core-shell type rubber particles, crosslinked acrylonitrile butadiene rubber particles, crosslinked styrene butadiene rubber particles, and acrylic rubber particles.

The average particle diameter D50 of the rubber particles is preferably 1 $\mu$m or less, and more preferably 0.8 $\mu$m or less.

A method for producing the resin composition is not particularly limited, and the resin composition can be produced by mixing the epoxy resin (A), the aluminum nitride filler (B), the alumina filler (C), and the optional component as necessary by a known method using, for example, a blender or a mixer.

In the mixing, the respective components may be simultaneously added and mixed in, for example, a mixer, or the respective components may be sequentially added and mixed in, for example, a mixer. The order of addition when the components are sequentially added to, for example, a mixer is not particularly limited. Further, the mixing may be performed under heating, or may be performed under an adjusted atmosphere such as an inert gas atmosphere as needed.

[Physical properties of resin composition]

The resin composition of the present invention has high fluidity and provides a cured product having low linear expansivity and high thermal conduction property.

The resin composition has high fluidity, so that a film made of the resin composition can follow the shape of a conductor layer of a multilayer printed wiring board, or a cavity and an electronic component of a component-embedded substrate, and adhesion between the film made of the resin composition and, for example, the conductor layer is improved.

The minimum value of the melt viscosity of the resin composition in a temperature range of 90 to 140°C is preferably 13000 poise or less, more preferably 9000 poise or less, and still more preferably 6000 poise or less.

In the production of a multilayer printed wiring board using a film made of the resin composition, hot pressing is usually performed by selecting an appropriate temperature in a range of 90 to 140°C. When the minimum value of the melt viscosity in a temperature range of 90 to 140°C is in the above range, a temperature near a temperature at which the melt viscosity reaches the minimum value can be selected as a temperature condition when the resin composition is shaped under heat and pressure for use in a multilayer printed wiring board and a component-embedded substrate. Therefore, the resin composition can be handled under the condition that the resin composition has high fluidity. The minimum value of the melt viscosity of the resin composition in a range of 90 to 140°C is preferably 300 poise or more, more preferably 500 poise or more from the viewpoint of handleability.

The melt viscosity of the resin composition is determined as a complex viscosity by performing temperature dispersion measurement of dynamic viscoelasticity using a viscoelasticity measuring apparatus (rotary rheometer).

The linear expansion coefficient of a cured product made of the resin composition is preferably 25 ppm/°C or less, and more preferably 22 ppm/°C or less. The closer the linear expansion coefficient of a cured product made of the resin composition is to the linear expansion coefficient of copper, which is a conductor layer, of 17 ppm/°C, the more preferable it is.

The linear expansion coefficient can be measured using a thermomechanical analyzer, and is obtained from the slope of the change in linear expansion coefficient up to the glass transition temperature.

The relative density of the resin composition is preferably 0.85 or more, more preferably 0.90 or more, still more preferably 0.95 or more, and particularly preferably 0.97 or more.

The relative density of the resin composition is represented by the ratio of the density obtained by measuring a cured product sample made of the resin composition to the density (theoretical density) obtained from the density and blending ratio of each component used, and is 1 when the theoretical density and the sample density match.

A high relative density indicates that the filling property of the filler in the resin composition is high, the resin composition has few defects such as voids, and the adhesion at the interface of each component is excellent. Therefore, when the relative density of the resin composition is high, the resin composition has excellent fluidity, and a cured product made of the resin composition tends to have, for example, excellent thermal conduction property, strength, and durability.

The upper limit value of the relative density is not particularly limited, but is preferably 1.1 or less, and more preferably 1.0 or less.

The density of a cured product made of the resin composition can be measured by an Archimedes method.

The thermal conductivity of a cured product made of the resin composition is preferably 3.5 W/m·K or more, more preferably 4.0 W/m·K or more, still more preferably 4.5 W/m·K or more, even more preferably 5.0 W/m·K or more, particularly preferably 5.5 W/m·K or more, and most preferably 6.0 W/m·K or more.

When the cured product has a high thermal conductivity, a film made of the resin composition can improve the heat dissipation of a multilayer printed wiring board and a component-embedded substrate.

The thermal conductivity is preferably as high as possible, but is generally 30 W/m·K or less.

The thermal conductivity can be measured by a temperature wave thermal analysis method (ai-Phase method).

(Use of resin composition)

The resin composition has high fluidity, and a cured product made of the resin composition has high thermal conduction property and low linear expansivity, so that the resin composition can be suitably used for an insulating layer of a multilayer printed wiring board and a sealing resin of a component-embedded substrate. In addition to these uses, the resin composition can be widely used in various uses requiring heat dissipation, such as an adhesive film, an insulating layer of a metal-clad laminate, an insulating resin sheet such as a prepreg, an underfill material, a die bonding material, a semiconductor sealing material, and a hole filling resin.

When the resin composition is used for uses requiring heat dissipation, it is industrially preferable to use the resin composition as a resin composition film obtained by shaping the resin composition into a film form.

The resin composition film of the present invention is obtained by shaping the resin composition of the present invention into a film.

The thickness of the resin composition film is preferably 5 to 250 $\mu$m, more preferably 10 to 200 $\mu$m, and still more

preferably 20 to 150 $\mu$m.

A method for producing the resin composition film is not particularly limited, and the resin composition film can be produced by a conventionally known method. Examples of a suitable method for producing the resin composition film include a method in which the resin composition is dissolved and mixed in an organic solvent to prepare a varnish, the varnish is applied onto a support using, for example, a die coater, and then the varnish is dried by, for example, heating and blowing hot air to remove the organic solvent.

Examples of the organic solvent include acetone, methanol, ethanol, butanol, 2-propanol, 2-methoxyethanol, 2-ethoxyethanol, 1-methoxy-2-propanol, 2-acetoxy-1-methoxypropane, toluene, xylene, methyl ethyl ketone, N,N-dimethylformamide, methyl isobutyl ketone, N-methylpyrrolidone, n-hexane, cyclohexane, cyclohexanone, and solvent naphtha which is a mixture thereof.

As the organic solvent, one type may be used alone, or two or more types may be used.

The boiling point of the organic solvent is preferably 200°C or lower, and more preferably 180°C or lower from the viewpoint of ease of removal of the organic solvent during drying. The content of the organic solvent in the varnish is not particularly limited, and may be appropriately adjusted in consideration of applicability to the support.

It is preferable to dry the varnish so that the total content of the organic solvent in the resin composition film is preferably 10 mass% or less, and more preferably 5 mass% or less.

It is possible to obtain the resin composition film that is not excessively thermally cured, for example, by heating and drying the varnish at 60°C to 150°C for 1 to 5 minutes although it depends on the boiling point of the organic solvent contained in the resin composition film.

It is preferable that the resin composition film is in a partially cured state and is a so-called B-stage film. When the resin composition film is in a partially cured state, the resin composition film is not completely cured, and therefore, when a multilayer printed wiring board and a component-embedded substrate are produced, the resin composition film can follow the shape of a conductor layer, and the strength and durability of the resin composition film can also be improved by allowing curing of the resin composition film to further proceed thereafter.

As the support, various plastic films can be suitably used.

Examples of the plastic film include polyester-based films such as a polyethylene terephthalate film, a polybutylene terephthalate film, and polyethylene naphthalate, olefin-based films such as a polyethylene film and a polypropylene film, and polyimide films, and among them, a polyethylene terephthalate film which is excellent in smoothness and heat resistance and is inexpensive is preferable.

From the viewpoint of, for example, wettability when the resin composition film is applied, and releasability when various semiconductor substrates are produced, the plastic film as the support on the coated surface side may be subjected to, for example, a mold release treatment, a matte treatment, or a corona discharge treatment.

As the support, a metal foil such as a copper foil or an aluminum foil may be used. As the copper foil, for example, a rolled copper foil and an electrolytic copper foil can be suitably used. Use of a metal foil as a support can omit a step of laminating a metal foil in production of various substrates, and can improve the adhesive strength between the support and the resin composition film.

The thickness of the support is not particularly limited, but is preferably in a range of 5 to 150 $\mu$m, more preferably 10 to 100 $\mu$m, and still more preferably 10 to 60 $\mu$m.

A protective film conforming to a support may be further laminated on a surface not in contact with the support in the resin composition film. The thickness of the protective film is not particularly limited, but is, for example, 5 to 40 $\mu$m.

Lamination of a protective film on a surface not in contact with the support in the resin composition film can prevent adhesion of, for example, dust to the surface of the resin composition film and scratches, and also enables winding of the resin composition film into a roll. When a multilayer printed wiring board, a component-embedded substrate, and other semiconductor materials are produced, the protective film is peeled off before use.

The resin composition film has high fluidity and embeddability, and a cured product made of the resin composition has high thermal conduction property and low linear expansivity, so that the resin composition film can be suitably used for formation of an insulating layer of a multilayer printed wiring board and a sealing resin of a component-embedded substrate. Further, the resin composition film can be widely used in various uses requiring heat dissipation, such as an adhesive film, an insulating layer of a metal-clad laminate, an insulating resin sheet such as a prepreg, an underfill material, a die bonding material, a semiconductor sealing material, and a hole filling resin.

Examples

Hereinafter, the present invention will be further specifically described with reference to Examples, but the present invention is not limited to these Examples.

The following components were used as materials of a resin composition.

<Epoxy resin (A)>

Solid epoxy resin (A-1)
Each of the following solid epoxy resins was dissolved in methyl ethyl ketone and used as a 50 mass% solution.
· EPPN-501HY (manufactured by Nippon Kayaku Co., Ltd., trisphenol methane type epoxy resin, epoxy equivalent: 166, softening point: 60°C)
· NC-3000 (manufactured by Nippon Kayaku Co., Ltd., biphenyl aralkyl type epoxy resin, epoxy equivalent: 276, softening point: 58°C)
. HP-4700 (manufactured by DIC Corporation, tetrafunctional naphthalene type epoxy resin, epoxy equivalent: 163, softening point: 92°C)
Liquid epoxy resin (A-2)
· jER 828 (manufactured by Mitsubishi Chemical Corporation, bisphenol A type epoxy resin, epoxy equivalent: 189, viscosity (25°C): 135 poise)
· YDF-8170C (manufactured by Nippon Steel Chemical & Materials Co., Ltd., bisphenol F type epoxy resin, epoxy equivalent: 155 to 165, viscosity: 10 to 15 poise)

<Aluminum nitride filler (B)>

<Untreated aluminum nitride filler>

HF-01D (manufactured by Tokuyama Corporation)
Aluminum nitride powder H-Grade (manufactured by Tokuyama Corporation)

As aluminum nitride fillers (B-1) to (B-4) and (B-6) to (B-10), those obtained by subjecting an untreated aluminum nitride filler to a surface treatment with a silane coupling agent (SC1) by the following method were used. As an aluminum nitride filler (B-5), an untreated aluminum nitride filler was used.
The combination of the untreated aluminum nitride filler and the silane coupling agent (SC1) is shown in Table 2.

<Method for producing aluminum nitride filler (B)>

A glass eggplant-shaped flask was charged with 600 g of an untreated aluminum nitride filler, 5 g of a silane coupling agent (SC1), and 1200 g of isopropyl alcohol, the resulting mixture was stirred with a fluororesin stirring blade for 30 minutes, then isopropyl alcohol was removed under reduced pressure at 50°C using a rotary evaporator, and the residue was dried under reduced pressure at 100°C to perform a surface treatment.

<Alumina filler (C)>

<Alumina filler (C0)>

As an alumina filler (C0), the following untreated alumina fillers were used.

· AA-03F (manufactured by Sumitomo Chemical Company, Limited)
· NXA-150 (manufactured by Sumitomo Chemical Company, Limited)
· AHPA-0.5AF (manufactured by Sasol Ltd.)
· AA-04 (manufactured by Sumitomo Chemical Company, Limited)
· ASFP-20 (manufactured by Denka Company Limited)
· AA-1.5 (manufactured by Sumitomo Chemical Company, Limited)

As alumina fillers (C-1) to (C-3) and an alumina filler (C-16), untreated alumina fillers were used. As alumina fillers (C-4) to (C-15) and an alumina filler (C-17), those obtained by subjecting an untreated alumina filler to a surface treatment with a silane coupling agent (SC2) by the following method were used.
The combination of the untreated alumina filler and the silane coupling agent (SC2) is shown in Table 3.

<Method for producing alumina filler (C)>

A glass eggplant-shaped flask was charged with 600 g of an untreated alumina filler, 5 g of a silane coupling agent (SC2), and 1200 g of isopropyl alcohol, the resulting mixture was stirred with a fluororesin stirring blade for 30 minutes, then isopropyl alcohol was removed under reduced pressure at 50°C using a rotary evaporator, and the residue was dried under reduced pressure at 100°C to perform a surface treatment.

<Silane coupling agent (SC1) and silane coupling agent (SC2)>

· N-Phenyl-3-aminopropyl trimethoxysilane (manufactured by Shin-Etsu Chemical Co., Ltd., KBM-573)
· 3-Methacryloxypropyltriethoxysilane (manufactured by Shin-Etsu Chemical Co., Ltd., KBE-503)
· 3-(Methylamino)propyltrimethoxysilane (manufactured by Tokyo Chemical Industry Co., Ltd., T2868)
· Phenyltrimethoxysilane (manufactured by Shin-Etsu Chemical Co., Ltd., KBM-103)
· 3-Aminopropyltrimethoxysilane (manufactured by Shin-Etsu Chemical Co., Ltd., KBM-903)
· 3-Acryloxypropyltrimethoxysilane (manufactured by Shin-Etsu Chemical Co., Ltd., KBM-5103)
· 3-Glycidoxypropyltriethoxysilane (manufactured by Shin-Etsu Chemical Co., Ltd., KBE-403)
· Octyltriethoxysilane (manufactured by Shin-Etsu Chemical Co., Ltd., KBE-3083)
· 8-Glycidoxyoctyltrimethoxysilane (manufactured by Shin-Etsu Chemical Co., Ltd., KBM-4803)

<Curing agent>

· GPH-103 (manufactured by Nippon Kayaku Co., Ltd., biphenyl aralkyl phenol novolac, hydroxy equivalent: 230, softening point: 103°C)
· PHENOLITE TD-2090-60M (manufactured by DIC Corporation, a methyl ethyl ketone solution of a phenol novolac resin having a hydroxy equivalent of 104 and a solid content of 60 mass%)
· HPC-8000-65T (manufactured by DIC Corporation, a toluene solution of an active ester-based curing agent having a dicyclopentadiene structure having an active ester group equivalent of 223 and a nonvolatile content of 65 mass%)

When GPH-103 was used, GPH-103 was dissolved in methyl ethyl ketone and used as a 50 mass% solution.

<Phenoxy resin>

· YX6954BH30 (manufactured by Mitsubishi Chemical Corporation, a cyclohexanone/methyl ethyl ketone (1/1) solution of a bisphenol acetophenone skeleton-containing phenoxy resin having a weight average molecular weight of 40670 and a nonvolatile content of 30 mass%)

<Curing accelerator>

· 4-Dimethylaminopyridine (DMAP, manufactured by FUJIFILM Wako Pure Chemical Corporation)

[Evaluation of physical properties of filler]

The physical properties of the untreated alumina filler, the aluminum nitride filler (B), and the alumina filler (C) were measured under the following conditions. The measurement results are shown in Tables 1 to 3.

<Average particle diameter and maximum particle diameter of filler>

With respect to a sample obtained by adding the untreated alumina filler, the aluminum nitride filler (B) or the alumina filler (C) to a dispersion medium so as to have a concentration of 0.2 mass%, followed by irradiation with an ultrasonic wave of about 200 W for 2 minutes to disperse the filler, the particle size distribution was measured using a laser diffraction scattering type particle size analyzer (manufactured by MicrotracBEL Corporation, MICROTRACK-MT3300EXII). As the dispersion medium, water was used in the case of dispersing the untreated aluminum nitride filler and the untreated alumina filler, and ethanol was used in the case of dispersing the surface-treated aluminum nitride filler and the surface-treated alumina filler. In the obtained volume frequency distribution (particle size distribution) of particle diameters, the volume frequency was accumulated from the smaller particle diameter, and the particle diameter at a cumulative value of 10% was defined as a 10% particle diameter D10, the particle diameter at a cumulative value of 50% was defined as an average particle diameter D50, the particle diameter at a cumulative value of 90% was defined as a 90% particle diameter D90, and the maximum value of the measured particle diameter (cumulative volume 100% particle diameter) was defined as a maximum particle diameter Dmax.

<Specific surface area of filler>

The specific surface area SA of each of the untreated alumina filler, the aluminum nitride filler (B), and the alumina filler (C) was determined by a BET method (nitrogen adsorption one-point method) using a flow-type specific surface area automatic measuring apparatus (manufactured by Shimadzu Corporation, Flow Sorb II-2300). In the measurement, 2 g of the untreated alumina filler, the aluminum nitride filler (B), or the alumina filler (C) in a powder form obtained by drying at 100°C for 1 hour under a nitrogen gas flow was used.

<Crystallite size of untreated alumina filler>

The powder X-ray diffraction profile of the untreated alumina filler was measured using an X-ray diffractometer (manufactured by Rigaku Corporation, SmartLab) under the following conditions: X-ray source: CuK$\alpha$ ray (wavelength: 0.15418 nm), X-ray output: 40 kV - 200 mA, 2$\theta$ range: 20 to 60°, and step width: 0.02°. A crystallite size calculated using the Scherrer equation based on the obtained half width of the diffraction peak attributed to the (104) plane of the $\alpha$-phase alumina in the vicinity of 2$\theta$ = 35.1° was defined as $L_{104}$. The Scherrer constant was set to 0.94.

<$\alpha$ Crystal content of untreated alumina filler>

From the powder X-ray diffraction profile obtained above, the $\alpha$ crystal content of the alumina filler was determined by the method described in JP 2007-055888 A. Specifically, the $\alpha$ crystal content was calculated according to the following formula (1) from the peak height ($I_{25.6}$) of the (012) plane of $\alpha$-phase alumina in the vicinity of 2$\theta$ = 25.6° and the peak height ($I_{46}$) of the y phase, $\eta$ phase, $\chi$ phase, $\kappa$ phase, $\theta$ phase, or $\delta$ phase appearing in the vicinity of 2$\theta$ = 46°.

$$\alpha \text{ Crystal content} = I_{25.6}/(I_{25.6} + I_{46}) \times 100\% \quad (1)$$

[Table 1]

Table 1

| Untreated alumina filler | 10% particle diameter D10 ($\mu$m) | Average particle diameter D50 ($\mu$m) | 90% particle diameter D90 ($\mu$m) | Specific surface area SA (m$^2$/g) | a crystal content (%) | Crystallite size $L_{104}$ (nm) | D50 ($\mu$m)$\times$ SA (m$^2$/g) | D50 ($\mu$m) /$L_{104}$($\mu$m) | D90 ($\mu$m) /D10 ($\mu$m) |
|---|---|---|---|---|---|---|---|---|---|
| AA-03F | 0.15 | 0.28 | 0.57 | 6.4 | 98.0 | 80.6 | 1.8 | 3.5 | 3.8 |
| NXA-150 | 0.11 | 0.20 | 0.32 | 9.7 | 97.9 | 70.8 | 1.9 | 2.8 | 2.9 |
| AA-04 | 0.22 | 0.45 | 1.08 | 4.5 | 98.4 | 87.1 | 2.0 | 5.2 | 4.9 |
| ASFP-20 | 0.20 | 0.30 | 1.00 | 12.5 | 13.9 | - | 3.8 | - | 5.0 |
| AHPA-0.5AF | 0.36 | 0.44 | 0.56 | 7.2 | 98.7 | 64.5 | 3.2 | 6.8 | 1.6 |
| AA-1.5 | - | 1.70 | - | 1.3 | - | - | 2.2 | - | - |

[Table 2]

Table 2

| Aluminum nitride filler (B) | Untreated aluminum nitride filler | Silane coupling agent (SC1) | Average particle diameter D50 (μm) | Maximum particle diameter Dmax (μm) | Specific surface area SA (m²/g) |
|---|---|---|---|---|---|
| B-1 | HF-01D | N-Phenyl-3-aminopropyl trimethoxysilane | 0.9 | 3.3 | 2.8 |
| B-2 | HF-01D | 3-Methacryloxypropyltriethoxysilane | 0.9 | 3.3 | 2.6 |
| B-3 | HF-01D | 3-Acryloxypropyltrimethoxysilane | 0.9 | 3.3 | 2.6 |
| B-4 | HF-01D | 3-Glycidoxypropyltriethoxysilane | 0.9 | 3.3 | 2.8 |
| B-5 | HF-01D | - | 0.9 | 3.3 | 2.7 |
| B-6 | HF-01D | Octyltriethoxysilane | 0.9 | 3.3 | 2.6 |
| B-7 | HF-01D | Phenyltrimethoxysilane | 0.9 | 3.3 | 2.8 |
| B-8 | HF-01D | 8-Glycidoxyoctyltrimethoxysilane | 0.9 | 3.3 | 2.7 |
| B-9 | H-Grade | N-Phenyl-3-aminopropyl trimethoxysilane | 1.1 | 6.5 | 2.6 |
| B-10 | H-Grade | 3-Methacryloxypropyltriethoxysilane | 1.1 | 6.5 | 2.4 |

[Table 3]

Table 3

| Alumina filler (C) | Untreated alumina filler | Silane coupling agent (SC2) | Average particle diameter D50 (μm) | Specific surface area SA (m²/g) |
|---|---|---|---|---|
| C-1 | AA-03F | - | 0.28 | 6.4 |
| C-2 | NXA-150 | - | 0.20 | 9.7 |
| C-3 | AHPA-0.5AF | - | 0.44 | 8.0 |
| C-4 | AA-03F | N-Phenyl-3-aminopropyl trimethoxysilane | 0.28 | 6.3 |
| C-5 | AA-03F | 3-Methacryloxypropyltriethoxysilane | 0.28 | 6.4 |
| C-6 | AA-03F | 3-(Methylamino)propyltrimethoxysilane | 0.28 | 6.5 |
| C-7 | NXA-150 | N-Phenyl-3-aminopropyl trimethoxysilane | 0.20 | 9.7 |
| C-8 | AA-04 | N-Phenyl-3-aminopropyl trimethoxysilane | 0.45 | 4.5 |
| C-9 | ASFP-20 | N-Phenyl-3-aminopropyl trimethoxysilane | 0.30 | 12.1 |
| C-10 | ASFP-20 | 3-Methacryloxypropyltriethoxysilane | 0.30 | 12.5 |
| C-11 | AHPA-0.5AF | N-Phenyl-3-aminopropyl trimethoxysilane | 0.44 | 7.0 |
| C-12 | AHPA-0.5AF | 3-(Methylamino)propyltrimethoxysilane | 0.44 | 7.2 |
| C-13 | AHPA-0.5AF | Phenyltrimethoxysilane | 0.44 | 7.3 |
| C-14 | AHPA-0.5AF | 3-Aminopropyltrimethoxysilane | 0.44 | 7.1 |

(continued)

| Alumina filler (C) | Untreated alumina filler | Silane coupling agent (SC2) | Average particle diameter D50 | Specific surface area SA (m²/g) |
|---|---|---|---|---|
| | | | (μm) | |
| C-15 | AHPA-0.5AF | 3-Methacryloxypropyltriethoxysilane | 0.44 | 7.0 |
| C-16 | AA-1.5 | - | 1.70 | 1.3 |
| C-17 | AA-1.5 | N-Phenyl-3-aminopropyl trimethoxysilane | 1.70 | 1.3 |

[Example 1]

In 50 parts by mass of a liquid epoxy resin (A-2) jER 828, 135 parts by mass of a curing agent HPC-8000-65T (nonvolatile content: 87.8 parts by mass), 33 parts by mass of a phenoxy resin YX6954BH30 (nonvolatile content: 9.9 parts by mass), 0.8 parts by mass of a curing accelerator DMAP, and 430 parts by mass of an alumina filler (C-1) were blended, followed by stirring and mixing.

To the mixed liquid, 100 parts by mass of a methyl ethyl ketone solution of a solid epoxy resin (A-1) NC3000 (nonvolatile content: 50 parts by mass), 740 parts by mass of an aluminum nitride filler (B-1), and 300 parts by mass of methyl ethyl ketone were added, and the resulting mixture was stirred for 30 minutes using a homodisper, and then kneaded using a three-roll mill.

Further, methyl ethyl ketone was appropriately added to adjust the viscosity, and then filtration and defoaming were performed to prepare a varnish of a resin composition.

Subsequently, the varnish of a resin composition was uniformly applied to the release-treated surface of a support (release-treated polyethylene terephthalate film (manufactured by Higashiyama Film Co., Ltd., HY-NS80, thickness: 38 μm)) so that the thickness after drying was 80 μm, and dried at 80°C for 3 minutes to prepare a resin composition film (stage B).

[Examples 2 to 22 and Comparative Examples 1 to 7]

Resin composition films were produced in the same manner as in Example 1 except that the formulation of the resin composition film was changed as shown in Tables 4 to 7.

[Examples 23 to 77 and Comparative Examples 8 to 13]

Resin composition films were produced in the same manner as in Example 1 except that the formulation of the resin composition film was changed as shown in Tables 8 to 15, and kneading using a three-roll mill was not performed after the mixture was stirred using a homodisper.

The mass of each component shown in Tables 4 to 15 represents the mass of a nonvolatile component.

[Evaluation of physical properties of resin composition]

The physical property measurement results of the resin compositions measured under the following conditions are shown in Tables 4 to 15.

<Minimum melt viscosity>

The resin composition film was peeled off from the support, and the melt viscosity was measured using a viscoelasticity measuring apparatus (rotary rheometer) (manufactured by Anton Paar GmbH, MCR302e). The dynamic viscoelasticity was measured with geometry: parallel plate with a diameter of 10 mm, gap: 1 mm, temperature range: 60°C to 180°C, frequency: 1 Hz, strain: 10%, and the minimum value of the complex viscosity in a range of 90 to 140°C was defined as the minimum melt viscosity.

<Linear expansion coefficient>

A resin composition film was cut into a strip shape having a width of 5 mm, and thermally cured by a heat treatment at 180°C for 90 minutes. The obtained cured product was continuously measured twice in a range of 30°C to 220°C by a tensile load method using a thermomechanical analyzer (manufactured by NETZSCH, TMA4000SE) at a sample length (between chucks) of 20 mm, a load of 1 g, and a heating rate of 5°C/min. The linear expansion coefficient was calculated from the slope of the change in linear expansion coefficient from 30°C to the glass transition temperature (the temperature at which the slope of the TMA curve changes) in the second measurement result.

<Thermal conductivity>

The resin composition film was thermally cured by a heat treatment at 180°C for 90 minutes. The thermal conductivity (W/m·K) of the obtained cured product was determined by thermal diffusivity ($m^2$/sec) $\times$ density ($kg/m^3$) $\times$ specific heat (J/kg·K). As the thermal diffusivity, an average value obtained by measuring the same test piece 12 times by a temperature wave thermal analysis method (manufactured by ai-Phase Co., Ltd., ai-Phase Mobile 1u, ISO 22007-3) was adopted. In addition, the density was measured by an Archimedes method (manufactured by Mettler Toledo, XS204V), and the specific heat was measured by a differential scanning calorimeter (DSC) method (manufactured by Rigaku Corporation, Thermo Plus Evo DSC8230).

<Relative density>

The relative density of the cured product prepared for measuring the thermal conductivity was calculated from the ratio between the measured value of the density measured above and the theoretical value obtained by calculation, that is, measured value/theoretical value. The theoretical value of the density was determined by calculation from the blending ratio of each component with the densities of the aluminum nitride filler (B), the alumina filler (C), and the remaining components excluding the filler component being 3.26 $g/m^3$, 3.98 $g/m^3$, and 1.17 $g/m^3$, respectively.

[Table 4]

Table 4

| | | | Example 1 | Example 2 | Example 3 | Example 4 | Example 5 | Example 6 | Example 7 | Example 8 |
|---|---|---|---|---|---|---|---|---|---|---|
| Solid epoxy resin (A-1) | EPPN-501HY | Parts by mass | | | | | | | | |
| | NC-3000 | Parts by mass | 50 | 50 | 50 | 50 | 50 | 50 | 50 | 50 |
| | HP-4700 | Parts by mass | | | | | | | | |
| Liquid epoxy resin (A-2) | jER-828 | Parts by mass | 50 | 50 | 50 | 50 | 50 | 50 | 50 | 50 |
| | YDF-8170C | Parts by mass | | | | | | | | |
| Aluminum nitride filler (B) | B-1 | Parts by mass | 740 | 550 | 740 | 740 | 580 | 930 | 1050 | 930 |
| | B-2 | Parts by mass | | | | | | | | |
| | B-3 | Parts by mass | | | | | | | | |
| | B-4 | Parts by mass | | | | | | | | |
| | B-5 | Parts by mass | | | | | | | | |
| | B-6 | Parts by mass | | | | | | | | |
| | B-7 | Parts by mass | | | | | | | | |
| | B-8 | Parts by mass | | | | | | | | |
| | B-9 | Parts by mass | | | | | | | | |
| | B-10 | Parts by mass | | | | | | | | |

| | | | Example 1 | Example 2 | Example 3 | Example 4 | Example 5 | Example 6 | Example 7 | Example 8 |
|---|---|---|---|---|---|---|---|---|---|---|
| Alumina filler (C) | C-1 | Parts by mass | 430 | 320 | | | 580 | 230 | 120 | |
| | C-2 | Parts by mass | | | 430 | | | | | 230 |
| | C-3 | Parts by mass | | | | 430 | | | | |
| | C-4 | Parts by mass | | | | | | | | |
| | C-5 | Parts by mass | | | | | | | | |
| | C-6 | Parts by mass | | | | | | | | |
| | C-7 | Parts by mass | | | | | | | | |
| | C-8 | Parts by mass | | | | | | | | |
| | C-9 | Parts by mass | | | | | | | | |
| | C-10 | Parts by mass | | | | | | | | |
| | C-11 | Parts by mass | | | | | | | | |
| | C-12 | Parts by mass | | | | | | | | |
| | C-13 | Parts by mass | | | | | | | | |
| | C-14 | Parts by mass | | | | | | | | |
| | C-15 | Parts by mass | | | | | | | | |
| | C-16 | Parts by mass | | | | | | | | |
| | C-17 | Parts by mass | | | | | | | | |
| Curing agent | GPH-103 | Parts by mass | | | | | | | | |
| | TD-2090-60M | Parts by mass | | | | | | | | |
| | HPC-8000-65T | Parts by mass | 87.8 | 87.8 | 87.8 | 87.8 | 87.8 | 87.8 | 87.8 | 87.8 |
| Phenoxy resin | YX6954BH30 | Parts by mass | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 |
| Total | | Parts by mass | 1368.5 | 1068.5 | 1368.5 | 1368.5 | 1358.5 | 1358.5 | 1368.5 | 1358.5 |
| Epoxy resin (A) | | Parts by mass | 100 | 100 | 100 | 100 | 100 | 100 | 100 | 100 |
| Sum of filler (B) + filler (C) | | Parts by mass | 1170 | 870 | 1170 | 1170 | 1160 | 1160 | 1170 | 1160 |
| Ratio of total surface areas of fillers (S2/S1) | | - | 1.33 | 1.33 | 2.01 | 1.66 | 2.29 | 0.57 | 0.26 | 0.86 |

(continued)

| | | Example 1 | Example 2 | Example 3 | Example 4 | Example 5 | Example 6 | Example 7 | Example 8 |
|---|---|---|---|---|---|---|---|---|---|
| Thermal conductivity | W/m·K | 5.05 | 3.87 | 4.49 | 4.38 | 3.70 | 4.36 | 3.74 | 4.61 |
| Relative density | - | 1.002 | 0.998 | 0.991 | 0.976 | 0.978 | 0.987 | 0.960 | 0.987 |
| Minimum melt viscosity | poise | 7,110 | 3,830 | 7,440 | 6,820 | 8,840 | 7,780 | 9,050 | 6,840 |
| Linear expansion coefficient | ppm/°C | 19.2 | 22.3 | 19.1 | 19.7 | 20.5 | 19.7 | 19.2 | 19.5 |

[Table 5]

[Table 5]

Table 5

| | | | Example 9 | Example 10 | Example 11 | Example 12 | Example 13 | Example 14 | Example 15 | Example 16 |
|---|---|---|---|---|---|---|---|---|---|---|
| Solid epoxy resin (A-1) | EPPN-501HY | Parts by mass | | | | | 50 | 50 | 75 | |
| | NC-3000 | Parts by mass | 50 | 50 | 50 | 50 | | | | |
| | HP-4700 | Parts by mass | | | | | | | | 50 |
| Liquid epoxy resin (A-2) | jER-828 | Parts by mass | 50 | 50 | 50 | 50 | 50 | 50 | 25 | 50 |
| | YDF-8170C | Parts by mass | | | | | | | | |
| Aluminum nitride filler (B) | B-1 | Parts by mass | 1050 | 930 | 1050 | 740 | 740 | 930 | 740 | 740 |
| | B-2 | Parts by mass | | | | | | | | |
| | B-3 | Parts by mass | | | | | | | | |
| | B-4 | Parts by mass | | | | | | | | |
| | B-5 | Parts by mass | | | | | | | | |
| | B-6 | Parts by mass | | | | | | | | |
| | B-7 | Parts by mass | | | | | | | | |
| | B-8 | Parts by mass | | | | | | | | |
| | B-9 | Parts by mass | | | | | | | | |

|  |  |  | Example 9 | Example 10 | Example 11 | Example 12 | Example 13 | Example 14 | Example 15 | Example 16 |
|---|---|---|---|---|---|---|---|---|---|---|
|  | B-10 | Parts by mass |  |  |  |  |  |  |  |  |
| Alumina filler (C) | C-1 | Parts by mass |  |  |  | 430 | 430 | 230 | 430 | 430 |
|  | C-2 | Parts by mass | 120 |  |  |  |  |  |  |  |
|  | C-3 | Parts by mass |  | 230 | 120 |  |  |  |  |  |
|  | C-4 | Parts by mass |  |  |  |  |  |  |  |  |
|  | C-5 | Parts by mass |  |  |  |  |  |  |  |  |
|  | C-6 | Parts by mass |  |  |  |  |  |  |  |  |
|  | C-7 | Parts by mass |  |  |  |  |  |  |  |  |
|  | C-8 | Parts by mass |  |  |  |  |  |  |  |  |
|  | C-9 | Parts by mass |  |  |  |  |  |  |  |  |
|  | C-10 | Parts by mass |  |  |  |  |  |  |  |  |
|  | C-11 | Parts by mass |  |  |  |  |  |  |  |  |
|  | C-12 | Parts by mass |  |  |  |  |  |  |  |  |
|  | C-13 | Parts by mass |  |  |  |  |  |  |  |  |
|  | C-14 | Parts by mass |  |  |  |  |  |  |  |  |

| | | | Example 9 | Example 10 | Example 11 | Example 12 | Example 13 | Example 14 | Example 15 | Example 16 |
|---|---|---|---|---|---|---|---|---|---|---|
| | C-15 | Parts by mass | | | | | | | | |
| | C-16 | Parts by mass | | | | | | | | |
| | C-17 | Parts by mass | | | | | | | | |
| Curing agent | GPH-103 | Parts by mass | | | | 90 | 90 | 90 | 90 | 90 |
| | TD-2090-60M | Parts by mass | | | | | | | | |
| | HPC-8000-65T | Parts by mass | 87.8 | 87.8 | 87.8 | | | | | |
| Phenoxy resin | YX6954BH30 | Parts by mass | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 |
| Total | | Parts by mass | 1368.5 | 1358.5 | 1368.5 | 1370.7 | 1370.7 | 1360.7 | 1370.7 | 1370.7 |
| Epoxy resin (A) | | Parts by mass | 100 | 100 | 100 | 100 | 100 | 100 | 100 | 100 |
| Sum of filler (B) + filler (C) | | Parts by mass | 1170 | 1160 | 1170 | 1170 | 1170 | 1160 | 1170 | 1170 |
| Ratio of total surface areas of fillers (S2/S1) | | - | 0.40 | 0.71 | 0.33 | 1.33 | 1.33 | 0.57 | 1.33 | 1.33 |
| Thermal conductivity | | W/m·K | 3.69 | 4.41 | 3.85 | 5.27 | 5.73 | 4.79 | 5.93 | 5.21 |
| Relative density | | - | 0.951 | 0.987 | 0.938 | 1.007 | 1.005 | 0.973 | 0.995 | 0.981 |
| Minimum melt viscosity | | poise | 6,930 | 6,550 | 7,210 | 7,430 | 7,880 | 7,120 | 9,470 | 9,350 |
| Linear expansion coefficient | | ppm/°C | 19.8 | 19.6 | 19.5 | 20.6 | 19.4 | 19.1 | 21.3 | 20.7 |

[Table 6]

Table 6]

| | | | Example 17 | Example 18 | Example 19 | Example 20 | Example 21 | Example 22 |
|---|---|---|---|---|---|---|---|---|
| Solid epoxy resin (A-1) | EPPN-501HY | Parts by mass | 50 | 50 | 50 | | 50 | 50 |
| | NC-3000 | Parts by mass | | | | 50 | | |
| | HP-4700 | Parts by mass | | | | | | |
| Liquid epoxy resin (A-2) | jER-828 | Parts by mass | 50 | 50 | 50 | 50 | 50 | 50 |
| | YDF-8170C | Parts by mass | | | | | | |
| Aluminum nitride filler (B) | B-1 | Parts by mass | | | | 1100 | | 740 |
| | B-2 | Parts by mass | 740 | 740 | 740 | | 740 | |
| | B-3 | Parts by mass | | | | | | |
| | B-4 | Parts by mass | | | | | | |
| | B-5 | Parts by mass | | | | | | |
| | B-6 | Parts by mass | | | | | | |
| | B-7 | Parts by mass | | | | | | |
| | B-8 | Parts by mass | | | | | | |
| | B-9 | Parts by mass | | | | | | |
| | B-10 | Parts by mass | | | | | | |

(continued)

| | | | Example 17 | Example 18 | Example 19 | Example 20 | Example 21 | Example 22 |
|---|---|---|---|---|---|---|---|---|
| Alumina filler (C) | C-1 | Parts by mass | 430 | | | 630 | 445 | 445 |
| | C-2 | Parts by mass | | 430 | | | | |
| | C-3 | Parts by mass | | | 430 | | | |
| | C-4 | Parts by mass | | | | | | |
| | C-5 | Parts by mass | | | | | | |
| | C-6 | Parts by mass | | | | | | |
| | C-7 | Parts by mass | | | | | | |
| | C-8 | Parts by mass | | | | | | |
| | C-9 | Parts by mass | | | | | | |
| | C-10 | Parts by mass | | | | | | |
| | C-11 | Parts by mass | | | | | | |
| | C-12 | Parts by mass | | | | | | |
| | C-13 | Parts by mass | | | | | | |
| | C-14 | Parts by mass | | | | | | |
| | C-15 | Parts by mass | | | | | | |
| | C-16 | Parts by mass | | | | | | |
| | C-17 | Parts by mass | | | | | | |
| Curing agent | GPH-103 | Parts by mass | 90 | 90 | 90 | | 90 | 90 |
| | TD-2090-60M | Parts by mass | | | | | | |
| | HPC-8000-65-T | Parts by mass | | | | 87.8 | | |
| Phenoxy resin | YX6954BH30 | Parts by mass | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 |

(continued)

| | | Example 17 | Example 18 | Example 19 | Example 20 | Example 21 | Example 22 |
|---|---|---|---|---|---|---|---|
| Total | Parts by mass | 1370.7 | 1370.7 | 1370.7 | 1928.5 | 1385.8 | 1385.8 |
| Epoxy resin (A) | Parts by mass | 100 | 100 | 100 | 100 | 100 | 100 |
| Sum of filler (B) + filler (C) | Parts by mass | 1170 | 1170 | 1170 | 1730 | 1185 | 1185 |
| Ratio of total surface areas of fillers (S2/S1) | - | 1.33 | 2.01 | 1.66 | 1.31 | 1.48 | 1.37 |
| Thermal conductivity | W/m·K | 5.85 | 4.83 | 5.21 | 3.62 | 5.85 | 5.73 |
| Relative density | - | 0.993 | 0.981 | 0.982 | 0.724 | 0.993 | 1.005 |
| Minimum melt viscosity | poise | 8,200 | 8,450 | 9,120 | 22,320 | 8,200 | 7,880 |
| Linear expansion coefficient | ppm/°C | 19.3 | 19.3 | 20.0 | 17.5 | 19.3 | 19.4 |

[Table 7]

Table 7

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| Solid epoxy resin (A-1) | EPPN-501HY | Parts by mass | | | | | | | |
| | NC-3000 | Parts by mass | 50 | 50 | 50 | 50 | 50 | 50 | 50 |
| | HP-4700 | Parts by mass | | | | | | | |
| Liquid epoxy resin (A-2) | jER-828 | Parts by mass | 50 | 50 | 50 | 50 | 50 | 50 | 50 |
| | YDF-8170C | Parts by mass | | | | | | | |
| Aluminum nitride filler (B) | B-1 | Parts by mass | 400 | | 700 | | 950 | | 740 |
| | B-2 | Parts by mass | | | | | | | |
| | B-3 | Parts by mass | | | | | | | |
| | B-4 | Parts by mass | | | | | | | |
| | B-5 | Parts by mass | | | | | | | |
| | B-6 | Parts by mass | | | | | | | |
| | B-7 | Parts by mass | | | | | | | |
| | B-8 | Parts by mass | | | | | | | |
| | B-9 | Parts by mass | | 700 | | 950 | | 740 | |
| | B-10 | Parts by mass | | | | | | | |

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| Alumina filler (C) | C-1 | Parts by mass | 230 | | | | | 430 | |
| | C-2 | Parts by mass | | | | | | | |
| | C-3 | Parts by mass | | | | | | | |
| | C-4 | Parts by mass | | | | | | | |
| | C-5 | Parts by mass | | | | | | | |
| | C-6 | Parts by mass | | | | | | | |
| | C-7 | Parts by mass | | | | | | | |
| | C-8 | Parts by mass | | | | | | | |
| | C-9 | Parts by mass | | | | | | | |
| | C-10 | Parts by mass | | | | | | | |
| | C-11 | Parts by mass | | | | | | | |
| | C-12 | Parts by mass | | | | | | | |
| | C-13 | Parts by mass | | | | | | | |
| | C-14 | Parts by mass | | | | | | | |
| | C-15 | Parts by mass | | | | | | | |
| | C-16 | Parts by mass | | | | | | | 430 |
| | C-17 | Parts by mass | | | | | | | |
| Curing agent | GPH-103 | Parts by mass | | | | | | | |
| | TD-2090-60M | Parts by mass | | | | | | | |
| | HPC-8000-65T | Parts by mass | 87.8 | 87.8 | 87.8 | 87.8 | 87.8 | 87.8 | 87.8 |
| Phenoxy resin | YX6954B H30 | Parts by mass | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 |
| Total | | Parts by mass | 828.5 | 898.5 | 898.5 | 1148.5 | 1148.5 | 1368.5 | 1368.5 |

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| Epoxy resin (A) | Parts by mass | 100 | 100 | 100 | 100 | 100 | 100 | 100 | |
| Sum of filler (B) + filler (C) | Parts by mass | 630 | 700 | 700 | 950 | 950 | 1170 | 1170 | |
| Ratio of total surface areas of fillers (S2/S1) | - | 1.31 | - | - | - | - | 1.43 | 0.27 | |
| Thermal conductivity | W/m·K | 2.81 | 2.46 | 2.84 | 2.42 | 3.23 | 3.42 | 2.20 | |
| Relative density | - | 1.000 | 0.726 | 0.891 | 0.631 | 0.823 | 0.897 | 0.842 | |
| Minimum melt viscosity | poise | 2,320 | 21,380 | 10,460 | 30,860 | 18,950 | 28,150 | 15,200 | |
| Linear expansion coefficient | ppm/°C | 26.5 | 24.8 | 21.7 | 21.8 | 20.3 | 20.2 | 20.2 | |

EP 4 711 416 A1

[Table 8]

Table 8

| | | | Example 23 | Example 24 | Example 25 | Example 26 | Example 27 | Example 28 | Example 29 | Example 30 |
|---|---|---|---|---|---|---|---|---|---|---|
| Solid epoxy resin (A-1) | EPPN-501HY | Parts by mass | 50 | 50 | 50 | 50 | 50 | 50 | 50 | 50 |
| | NC-3000 | Parts by mass | | | | | | | | |
| | HP-4700 | Parts by mass | | | | | | | | |
| Liquid epoxy resin (A-2) | jER-828 | Parts by mass | 50 | 50 | 50 | 50 | 50 | 50 | 50 | 50 |
| | YDF-8170C | Parts by mass | | | | | | | | |
| Aluminum nitride filler (B) | B-1 | Parts by mass | | | | | | | 740 | |
| | B-2 | Parts by mass | 610 | 740 | 580 | 880 | 940 | 1000 | | |
| | B-3 | Parts by mass | | | | | | | | 740 |
| | B-4 | Parts by mass | | | | | | | | |
| | B-5 | Parts by mass | | | | | | | | |
| | B-6 | Parts by mass | | | | | | | | |
| | B-7 | Parts by mass | | | | | | | | |
| | B-8 | Parts by mass | | | | | | | | |
| | B-9 | Parts by mass | | | | | | | | |

40

(continued)

| | | Example 23 | Example 24 | Example 25 | Example 26 | Example 27 | Example 28 | Example 29 | Example 30 |
|---|---|---|---|---|---|---|---|---|---|
| | B-10 | Parts by mass | | | | | | | |
| | C-1 | Parts by mass | | | | | | | |
| | C-2 | Parts by mass | | | | | | | |
| | C-3 | Parts by mass | | | | | | | |
| | C-4 | Parts by mass | 610 | 445 | 350 | 530 | 230 | 110 | | |
| | C-5 | Parts by mass | | | | | | | 445 | |
| | C-6 | Parts by mass | | | | | | | | 445 |
| | C-7 | Parts by mass | | | | | | | | |
| Alumina filler (C) | C-8 | Parts by mass | | | | | | | | |
| | C-9 | Parts by mass | | | | | | | | |
| | C-10 | Parts by mass | | | | | | | | |
| | C-11 | Parts by mass | | | | | | | | |
| | C-12 | Parts by mass | | | | | | | | |
| | C-13 | Parts by mass | | | | | | | | |
| | C-14 | Parts by mass | | | | | | | | |

| | | | Example 23 | Example 24 | Example 25 | Example 26 | Example 27 | Example 28 | Example 29 | Example 30 |
|---|---|---|---|---|---|---|---|---|---|---|
| | C-15 | Parts by mass | | | | | | | | |
| | C-16 | Parts by mass | | | | | | | | |
| | C-17 | Parts by mass | | | | | | | | |
| Curing agent | GPH-103 | Parts by mass | 90 | 90 | 90 | 90 | 90 | 90 | 90 | 90 |
| | TD-2090-60M | Parts by mass | | | | | | | | |
| | HPC-8000-65T | Parts by mass | | | | | | | | |
| Phenoxy resin | YX6954BH30 | Parts by mass | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 |
| Total | | Parts by mass | 1420.8 | 1385.8 | 1130.8 | 1610.8 | 1370.8 | 1310.8 | 1385.8 | 1385.8 |
| Epoxy resin (A) | | Parts by mass | 100 | 100 | 100 | 100 | 100 | 100 | 100 | 100 |
| Sum of filler (B) + filler (C) | | Parts by mass | 1220 | 1185 | 930 | 1410 | 1170 | 1110 | 1185 | 1185 |
| Ratio of total surface areas of fillers (S2/S1) | | - | 2.42 | 1.46 | 1.46 | 1.46 | 0.59 | 0.27 | 1.37 | 1.46 |
| Thermal conductivity | | W/m·K | 4.15 | 5.38 | 4.04 | 3.87 | 4.21 | 4.35 | 5.08 | 4.68 |
| Relative density | | - | 0.932 | 1.006 | 1.010 | 0.924 | 0.972 | 0.935 | 0.975 | 0.976 |
| Minimum melt viscosity | | poise | 8,120 | 6,600 | 2,740 | 9,210 | 6,840 | 7,530 | 7,060 | 7,120 |
| Linear expansion coefficient | | ppm/°C | 20.2 | 19.4 | 22.5 | 17.3 | 19.6 | 19.4 | 20.8 | 20.6 |

[Table 9]

[Table 9]

Table 9

| | | | Example 31 | Example 32 | Example 33 | Example 34 | Example 35 | Example 36 | Example 37 |
|---|---|---|---|---|---|---|---|---|---|
| Solid epoxy resin (A-1) | EPPN-501HY | Parts by mass | 50 | 50 | 50 | | 50 | 50 | 50 |
| | NC-3000 | Parts by mass | | | | 50 | | | |
| | HP-4700 | Parts by mass | | | | | | | |
| Liquid epoxy resin (A-2) | jER-828 | Parts by mass | 50 | 50 | | 50 | 50 | 50 | 50 |
| | YDF-8170C | Parts by mass | | | 50 | | | | |
| Aluminum nitride filler (B) | B-1 | Parts by mass | | | | | | | |
| | B-2 | Parts by mass | 740 | 740 | 740 | 740 | | | 740 |
| | B-3 | Parts by mass | | | | | | | |
| | B-4 | Parts by mass | | | | | 740 | 740 | |
| | B-5 | Parts by mass | | | | | | | |
| | B-6 | Parts by mass | | | | | | | |
| | B-7 | Parts by mass | | | | | | | |
| | B-8 | Parts by mass | | | | | | | |
| | B-9 | Parts by mass | | | | | | | |
| | B-10 | Parts by mass | | | | | | | |

| | | | Example 31 | Example 32 | Example 33 | Example 34 | Example 35 | Example 36 | Example 37 |
|---|---|---|---|---|---|---|---|---|---|
| Alumina filler (C) | C-1 | Parts by mass | | | | | | | |
| | C-2 | Parts by mass | | | | | | | |
| | C-3 | Parts by mass | | | | | | | |
| | C-4 | Parts by mass | | | 445 | 445 | | | |
| | C-5 | Parts by mass | | | | | | | |
| | C-6 | Parts by mass | | | | | | | 445 |
| | C-7 | Parts by mass | 445 | | | | | | |
| | C-8 | Parts by mass | | 445 | | | | | |
| | C-9 | Parts by mass | | | | | 445 | | |
| | C-10 | Parts by mass | | | | | | 445 | |
| | C-11 | Parts by mass | | | | | | | |
| | C-12 | Parts by mass | | | | | | | |
| | C-13 | Parts by mass | | | | | | | |
| | C-14 | Parts by mass | | | | | | | |
| | C-15 | Parts by mass | | | | | | | |
| | C-16 | Parts by mass | | | | | | | |
| | C-17 | Parts by mass | | | | | | | |
| Curing agent | GPH-103 | Parts by mass | 90 | 90 | 90 | | 90 | 90 | 90 |
| | TD-2090-60M | Parts by mass | | | | 90 | | | |
| | HPC-8000-65T | Parts by mass | | | | | | | |
| Phenoxy resin | YX6954BH30 | Parts by mass | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 |
| Total | | Parts by mass | 1385.8 | 1385.8 | 1385.8 | 1385.8 | 1385.8 | 1385.8 | 1385.8 |
| Epoxy resin (A) | | Parts by mass | 100 | 100 | 100 | 100 | 100 | 100 | 100 |
| Sum of filler (B) + filler (C) | | Parts by mass | 1185 | 1185 | 1185 | 1185 | 1185 | 1185 | 1185 |
| Ratio of total surface areas of fillers (S2/S1) | | - | 2.24 | 1.04 | 1.46 | 1.46 | 2.60 | 2.68 | 1.50 |

(continued)

|  |  | Example 31 | Example 32 | Example 33 | Example 34 | Example 35 | Example 36 | Example 37 |
|---|---|---|---|---|---|---|---|---|
| Thermal conductivity | W/m·K | 5.13 | 4.10 | 5.36 | 4.35 | 3.84 | 3.62 | 4.48 |
| Relative density | - | 0.985 | 0.945 | 0.987 | 0.993 | 0.902 | 0.875 | 0.931 |
| Minimum melt viscosity | poise | 7,420 | 9,870 | 6,120 | 5,870 | 10,520 | 12,160 | 8,580 |
| Linear expansion coefficient | ppm/°C | 21.0 | 19.2 | 20.3 | 19.2 | 20.2 | 20.3 | 19.6 |

[Table 10]

[Table 10]

Table 10

| | | | Example 38 | Example 39 | Example 40 | Example 41 | Example 42 | Example 43 | Example 44 | Example 45 |
|---|---|---|---|---|---|---|---|---|---|---|
| Solid epoxy resin (A-1) | EPPN-501HY | Parts by mass | 50 | 50 | 50 | 50 | 50 | 50 | 50 | 50 |
| | NC-3000 | Parts by mass | | | | | | | | |
| | HP-4700 | Parts by mass | | | | | | | | |
| Liquid epoxy resin (A-2) | jER-828 | Parts by mass | 50 | 50 | 50 | 50 | 50 | 50 | 50 | 50 |
| | YDF-8170C | Parts by mass | | | | | | | | |
| Aluminum nitride filler (B) | B-1 | Parts by mass | | 740 | | | | | 740 | |
| | B-2 | Parts by mass | 740 | | | | | 740 | | 1050 |
| | B-3 | Parts by mass | | | | | | | | |
| | B-4 | Parts by mass | | | | | | | | |
| | B-5 | Parts by mass | | | 740 | | | | | |
| | B-6 | Parts by mass | | | | 740 | | | | |
| | B-7 | Parts by mass | | | | | 740 | | | |
| | B-8 | Parts by mass | | | | | | | | |
| | B-9 | Parts by mass | | | | | | | | |

48

| | | | Example 38 | Example 39 | Example 40 | Example 41 | Example 42 | Example 43 | Example 44 | Example 45 |
|---|---|---|---|---|---|---|---|---|---|---|
| | B-10 | Parts by mass | | | | | | | | |
| Alumina filler (C) | C-1 | Parts by mass | | | | | | 445 | 445 | |
| | C-2 | Parts by mass | | | | | | | | |
| | C-3 | Parts by mass | | | | | | | | |
| | C-4 | Parts by mass | | 445 | 445 | 445 | 445 | | | 630 |
| | C-5 | Parts by mass | 445 | | | | | | | |
| | C-6 | Parts by mass | | | | | | | | |
| | C-7 | Parts by mass | | | | | | | | |
| | C-8 | Parts by mass | | | | | | | | |
| | C-9 | Parts by mass | | | | | | | | |
| | C-10 | Parts by mass | | | | | | | | |
| | C-11 | Parts by mass | | | | | | | | |
| | C-12 | Parts by mass | | | | | | | | |
| | C-13 | Parts by mass | | | | | | | | |
| | C-14 | Parts by mass | | | | | | | | |

EP 4 711 416 A1

| | | | Example 38 | Example 39 | Example 40 | Example 41 | Example 42 | Example 43 | Example 44 | Example 45 |
|---|---|---|---|---|---|---|---|---|---|---|
| | C-15 | Parts by mass | | | | | | | | |
| | C-16 | Parts by mass | | | | | | | | |
| | C-17 | Parts by mass | | | | | | | | |
| Curing agent | GPH-103 | Parts by mass | 90 | 90 | 90 | 90 | 90 | 90 | 90 | 90 |
| | TD-2090-60M | Parts by mass | | | | | | | | |
| | HPC-8000-65T | Parts by mass | | | | | | | | |
| Phenoxy resin | YX6954BH30 | Parts by mass | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 |
| Total | | Parts by mass | 1385.8 | 1385.8 | 1385.8 | 1385.8 | 1385.8 | 1385.8 | 1385.8 | 1880.8 |
| Epoxy resin (A) | | Parts by mass | 100 | 100 | 100 | 100 | 100 | 100 | 100 | 100 |
| Sum of filler (B) + filler (C) | | Parts by mass | 1185 | 1185 | 1185 | 1185 | 1185 | 1185 | 1185 | 1680 |
| Ratio of total surface areas of fillers (S2/S1) | | | 1.48 | 1.35 | 1.40 | 1.46 | 1.35 | 1.48 | 1.37 | 1.45 |
| Thermal conductivity | | W/m·K | 2.31 | 2.57 | 4.74 | 5.49 | 5.64 | 4.52 | 4.66 | 3.24 |
| Relative density | | - | 0.764 | 0.875 | 0.747 | 0.851 | 0.926 | 0.842 | 0.880 | 0.838 |
| Minimum melt viscosity | | poise | 17,060 | 15,500 | 28,730 | 26,669 | 20,740 | 20,050 | 18,940 | 15,760 |
| Linear expansion coefficient | | ppm/°C | 22.8 | 21.7 | 21.0 | 20.7 | 20.4 | 20.0 | 20.2 | 17.5 |

[Table 11]

Table 11

| | | Example 46 | Example 47 | Example 48 | Example 49 | Example 50 | Example 51 | Example 52 | Example 53 | Example 54 |
|---|---|---|---|---|---|---|---|---|---|---|
| Solid epoxy resin (A-1) | EPPN-501HY | Parts by mass | 50 | 50 | 50 | 50 | 50 | 50 | 50 | 50 | 50 |
| | NC-3000 | Parts by mass | | | | | | | | | |
| | HP-4700 | Parts by mass | | | | | | | | | |
| Liquid epoxy resin (A-2) | jER-828 | Parts by mass | 50 | 50 | 50 | 50 | 50 | 50 | 50 | 50 | |
| | YDF-8170C | Parts by mass | | | | | | | | | 50 |

(continued)

| Aluminum nitride filler (B) | | | Example 46 | Example 47 | Example 48 | Example 49 | Example 50 | Example 51 | Example 52 | Example 53 | Example 54 |
|---|---|---|---|---|---|---|---|---|---|---|---|
| | B-1 | Parts by mass | | | | | | | | | |
| | B-2 | Parts by mass | 1100 | 1200 | 1000 | 1120 | 1400 | 1530 | 920 | 740 | 1000 |
| | B-3 | Parts by mass | | | | | | | | | |
| | B-4 | Parts by mass | | | | | | | | | |
| | B-5 | Parts by mass | | | | | | | | | |
| | B-6 | Parts by mass | | | | | | | | | |
| | B-7 | Parts by mass | | | | | | | | | |
| | B-8 | Parts by mass | | | | | | | | | |
| | B-9 | Parts by mass | | | | | | | | | |
| | B-10 | Parts by mass | | | | | | | | | |

| | | | Example 46 | Example 47 | Example 48 | Example 49 | Example 50 | Example 51 | Example 52 | Example 53 | Example 54 |
|---|---|---|---|---|---|---|---|---|---|---|---|
| Alumina filler (C) | C-1 | Parts by mass | | | | | | | | | |
| | C-2 | Parts by mass | | | | | | | | | |
| | C-3 | Parts by mass | | | | | | | | | |
| | C-4 | Parts by mass | | | | | | | | | |
| | C-5 | Parts by mass | | | | | | | | | |
| | C-6 | Parts by mass | | | | | | | | | |
| | C-7 | Parts by mass | | | | | | | | | |
| | C-8 | Parts by mass | | | | | | | | | |
| | C-9 | Parts by mass | | | | | | | | | |
| | C-10 | Parts by mass | | | | | | | | | |
| | C-11 | Parts by mass | 270 | 135 | 250 | 125 | 155 | 170 | 230 | 445 | 250 |
| | C-12 | Parts by mass | | | | | | | | | |
| | C-13 | Parts by mass | | | | | | | | | |

EP 4 711 416 A1

54

| | | | Example 46 | Example 47 | Example 48 | Example 49 | Example 50 | Example 51 | Example 52 | Example 53 | Example 54 |
|---|---|---|---|---|---|---|---|---|---|---|---|
| | C-14 | Parts by mass | | | | | | | | | |
| | C-15 | Parts by mass | | | | | | | | | |
| | C-16 | Parts by mass | | | | | | | | | |
| | C-17 | Parts by mass | | | | | | | | | |
| | C-14 | Parts by mass | | | | | | | | | |
| | C-15 | Parts by mass | | | | | | | | | |
| | C-16 | Parts by mass | | | | | | | | | |
| | C-17 | Parts by mass | | | | | | | | | |
| Curing agent | GPH-103 | Parts by mass | 90 | 90 | 90 | 90 | 90 | 90 | 90 | 90 | 90 |
| | TD-2090-60M | Parts by mass | | | | | | | | | |
| | HPC-8000-65T | Parts by mass | | | | | | | | | |
| Phenoxy resin | YX6954B H30 | Parts by mass | 9.9 | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 | 0.8 |
| Total | | Parts by mass | 1570.8 | 1535.8 | 1450.8 | 1445.8 | 1755.8 | 1900.8 | 1350.8 | 1385.8 | 1450.8 |
| Epoxy resin (A) | | Parts by mass | 100 | 100 | 100 | 100 | 100 | 100 | 100 | 100 | 100 |

| | | Example 46 | Example 47 | Example 48 | Example 49 | Example 50 | Example 51 | Example 52 | Example 53 | Example 54 |
|---|---|---|---|---|---|---|---|---|---|---|
| Sum of filler (B) + filler (C) | Parts by mass | 1370 | 1335 | 1250 | 1245 | 1555 | 1700 | 1150 | 1185 | 1250 |
| Ratio of total surface areas of fillers (S2/S1) | - | 0.66 | 0.30 | 0.67 | 0.30 | 0.30 | 0.30 | 0.67 | 1.62 | 0.67 |
| Thermal conductivity | W/m·K | 4.53 | 4.32 | 4.21 | 4.08 | 4.09 | 3.18 | 3.58 | 3.88 | 4.30 |
| Relative density | - | 0.987 | 0.985 | 0.992 | 1.008 | 0.960 | 0.812 | 0.985 | 0.974 | 0.987 |
| Minimum melt viscosity | poise | 4,049 | 3,173 | 2,580 | 1,889 | 4,860 | 5,830 | 2,550 | 3,040 | 2,350 |
| Linear expansion coefficient | ppm/°C | 16.9 | 16.8 | 18.4 | 18.3 | 16.5 | 16.2 | 19.8 | 20.1 | 18.5 |

[Table 12]

Table 12

| | | | Example 55 | Example 56 | Example 57 | Example 58 | Example 59 | Example 60 | Example 61 | Example 62 | Example 63 |
|---|---|---|---|---|---|---|---|---|---|---|---|
| Solid epoxy resin (A-1) | EPPN-501HY | Parts by mass | | 50 | 50 | 50 | 50 | 50 | 50 | 50 | 50 |
| | NC-3000 | Parts by mass | 50 | | | | | | | | |
| | HP-4700 | Parts by mass | | | | | | | | | |
| Liquid epoxy resin (A-2) | jER-828 | Parts by mass | 50 | 50 | 50 | 50 | 50 | 50 | 50 | 50 | 50 |
| | YDF-8170C | Parts by mass | | | | | | | | | |
| Aluminum nitride filler (B) | B-1 | Parts by mass | | | | | | | | | 1000 |
| | B-2 | Parts by mass | 1000 | | 1000 | 940 | | | 920 | 1000 | |
| | B-3 | Parts by mass | | 1000 | | | | | | | |
| | B-4 | Parts by mass | | | | | | | | | |
| | B-5 | Parts by mass | | | | | | | | | |
| | B-6 | Parts by mass | | | | | 920 | | | | |
| | B-7 | Parts by mass | | | | | | 920 | | | |
| | B-8 | Parts by mass | | | | | | | | | |
| | B-9 | Parts by mass | | | | | | | | | |

EP 4 711 416 A1

58

| | | | Example 55 | Example 56 | Example 57 | Example 58 | Example 59 | Example 60 | Example 61 | Example 62 | Example 63 |
|---|---|---|---|---|---|---|---|---|---|---|---|
| | B-10 | Parts by mass | | | | | | | | | |
| Alumina filler (C) | C-1 | Parts by mass | | | | | | | | | |
| | C-2 | Parts by mass | | | | | | | | | |
| | C-3 | Parts by mass | | | | | | | | | |
| | C-4 | Parts by mass | | | | | | | | | |
| | C-5 | Parts by mass | | | | | | | | | |
| | C-6 | Parts by mass | | | | | | | | | |
| | C-7 | Parts by mass | | | | 230 | | | | | |
| | C-8 | Parts by mass | | | | | | | | | |
| | C-9 | Parts by mass | | | | | | | | | |
| | C-10 | Parts by mass | | | | | | | | | |
| | C-11 | Parts by mass | 250 | 250 | | | 230 | 230 | | | |
| | C-12 | Parts by mass | | | 250 | | | | | | |
| | C-13 | Parts by mass | | | | | | | 230 | | |
| | C-14 | Parts by mass | | | | | | | | 250 | |

EP 4 711 416 A1

59

| | | | Example 55 | Example 56 | Example 57 | Example 58 | Example 59 | Example 60 | Example 61 | Example 62 | Example 63 |
|---|---|---|---|---|---|---|---|---|---|---|---|
| | C-15 | Parts by mass | | | | | | | | | 250 |
| | C-16 | Parts by mass | | | | | | | | | |
| | C-17 | Parts by mass | | | | | | | | | |
| Curing agent | GPH-103 | Parts by mass | | 90 | 90 | 90 | 90 | 90 | 90 | 90 | 90 |
| | TD-2090-60M | Parts by mass | 90 | | | | | | | | |
| | HPC-8000-65T | Parts by mass | | | | | | | | | |
| Phenoxy resin | YX6954BH30 | Parts by mass | 9.9 | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 | 0.8 |
| Total | | Parts by mass | 1450.8 | 1450.8 | 1450.8 | 1370.8 | 1350.8 | 1350.8 | 1350.8 | 1450.8 | 1450.8 |
| Epoxy resin (A) | | Parts by mass | 100 | 100 | 100 | 100 | 100 | 100 | 100 | 100 | 100 |
| Sum of filler (B) + filler (C) | | Parts by mass | 1250 | 1250 | 1250 | 1170 | 1150 | 1150 | 1150 | 1250 | 1250 |
| Ratio of total surface areas of fillers (S2/S1) | | - | 0.67 | 0.67 | 0.69 | 0.91 | 0.67 | 0.63 | 0.70 | 0.68 | 0.63 |
| Thermal conductivity | | W/m·K | 4.01 | 3.98 | 4.06 | 3.85 | 3.98 | 4.18 | 2.97 | 3.62 | 3.85 |
| Relative density | | - | 0.976 | 0.977 | 0.956 | 0.961 | 0.924 | 0.946 | 0.875 | 0.893 | 0.933 |
| Minimum melt viscosity | | poise | 2,460 | 2,960 | 4,810 | 6,980 | 12,800 | 12,200 | 9,350 | 11,460 | 8,580 |
| Linear expansion coefficient | | ppm/°C | 18.1 | 18.5 | 18.6 | 20.2 | 19.7 | 19.7 | 19.9 | 18.6 | 18.4 |

EP 4 711 416 A1

[Table 13]

Table 13

| | | | Example 64 | Example 65 | Example 66 | Example 67 | Example 68 | Example 69 | Example 70 | Example 71 |
|---|---|---|---|---|---|---|---|---|---|---|
| Solid epoxy resin (A-1) | EPPN-501 HY | Parts by mass | 50 | 50 | 50 | 50 | 50 | 50 | 50 | 50 |
| | NC-3000 | Parts by mass | | | | | | | | |
| | HP-4700 | Parts by mass | | | | | | | | |
| Liquid epoxy resin (A-2) | jER-828 | Parts by mass | 50 | 50 | 50 | 50 | 50 | 50 | 50 | |
| | YDF-8170C | Parts by mass | | | | | | | | 50 |
| Aluminum nitride filler (B) | B-1 | Parts by mass | | | | | | | | |
| | B-2 | Parts by mass | | | | | | | | |
| | B-3 | Parts by mass | | | | | | | | |
| | B-4 | Parts by mass | 740 | 580 | 880 | 940 | 610 | 740 | 740 | 740 |
| | B-5 | Parts by mass | | | | | | | | |
| | B-6 | Parts by mass | | | | | | | | |
| | B-7 | Parts by mass | | | | | | | | |
| | B-8 | Parts by mass | | | | | | | | |
| | B-9 | Parts by mass | | | | | | | | |

| | | | Example 64 | Example 65 | Example 66 | Example 67 | Example 68 | Example 69 | Example 70 | Example 71 |
|---|---|---|---|---|---|---|---|---|---|---|
| | B-10 | Parts by mass | | | | | | | | |
| Alumina filler (C) | C-1 | Parts by mass | | | | | | | | |
| | C-2 | Parts by mass | | | | | | | | |
| | C-3 | Parts by mass | | | | | | | | |
| | C-4 | Parts by mass | 445 | 350 | 530 | 230 | 610 | | | 445 |
| | C-5 | Parts by mass | | | | | | | | |
| | C-6 | Parts by mass | | | | | | | | |
| | C-7 | Parts by mass | | | | | | 445 | | |
| | C-8 | Parts by mass | | | | | | | 445 | |
| | C-9 | Parts by mass | | | | | | | | |
| | C-10 | Parts by mass | | | | | | | | |
| | C-11 | Parts by mass | | | | | | | | |
| | C-12 | Parts by mass | | | | | | | | |
| | C-13 | Parts by mass | | | | | | | | |
| | C-14 | Parts by mass | | | | | | | | |

| | | | Example 64 | Example 65 | Example 66 | Example 67 | Example 68 | Example 69 | Example 70 | Example 71 |
|---|---|---|---|---|---|---|---|---|---|---|
| | C-15 | Parts by mass | | | | | | | | |
| | C-16 | Parts by mass | | | | | | | | |
| | C-17 | Parts by mass | | | | | | | | |
| Curing agent | GPH-103 | Parts by mass | 90 | 90 | 90 | 90 | 90 | 90 | 90 | 90 |
| | TD-2090-60M | Parts by mass | | | | | | | | |
| | HPC-8000-65T | Parts by mass | | | | | | | | |
| Phenoxy resin | YX6954BH30 | Parts by mass | 9.9 | 9.9 | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 | 0.8 | 0.8 |
| Total | | Parts by mass | 1385.8 | 1130.8 | 1610.8 | 1370.8 | 1420.8 | 1385.8 | 1385.8 | 1385.8 |
| Epoxy resin (A) | | Parts by mass | 100 | 100 | 100 | 100 | 100 | 100 | 100 | 100 |
| Sum of filler (B) + filler (C) | | Parts by mass | 1185 | 930 | 1410 | 1170 | 1220 | 1185 | 1185 | 1185 |
| Ratio of total surface areas of fillers (S2/S1) | | | 1.35 | 1.36 | 1.36 | 0.55 | 2.25 | 2.08 | 0.97 | 1.35 |
| Thermal conductivity | | W/m·K | 6.91 | 6.14 | 6.22 | 6.53 | 6.21 | 6.13 | 5.82 | 6.45 |
| Relative density | | - | 1.009 | 0.994 | 0.924 | 0.996 | 0.921 | 0.942 | 0.924 | 0.976 |
| Minimum melt viscosity | | poise | 7,103 | 5,610 | 9,860 | 6,980 | 8,560 | 7,620 | 9,530 | 6,840 |
| Linear expansion coefficient | | ppm/°C | 19.5 | 22.2 | 17.5 | 19.6 | 19.2 | 19.8 | 19.1 | 19.8 |

[Table 14]

Table 14

| | | | Example 72 | Example 73 | Example 74 | Example 75 | Example 76 | Example 77 |
|---|---|---|---|---|---|---|---|---|
| Solid epoxy resin (A-1) | EPPN-501HY | Parts by mass | | 50 | 50 | 50 | 50 | 50 |
| | NC-3000 | Parts by mass | 50 | | | | | |
| | HP-4700 | Parts by mass | | | | | | |
| Liquid epoxy resin (A-2) | jER-828 | Parts by mass | 50 | 50 | 50 | 50 | 50 | 50 |
| | YDF-8170C | Parts by mass | | | | | | |
| Aluminum nitride filler (B) | B-1 | Parts by mass | | | | | 740 | |
| | B-2 | Parts by mass | | | | | | |
| | B-3 | Parts by mass | | | | | | |
| | B-4 | Parts by mass | 740 | | 740 | 740 | | 1050 |
| | B-5 | Parts by mass | | | | | | |
| | B-6 | Parts by mass | | | | | | |
| | B-7 | Parts by mass | | | | | | |
| | B-8 | Parts by mass | | 740 | | | | |
| | B-9 | Parts by mass | | | | | | |
| | B-10 | Parts by mass | | | | | | |

(continued)

| | | | Example 72 | Example 73 | Example 74 | Example 75 | Example 76 | Example 77 |
|---|---|---|---|---|---|---|---|---|
| Alumina filler (C) | C-1 | Parts by mass | | | | | | |
| | C-2 | Parts by mass | | | | | | |
| | C-3 | Parts by mass | | | | | | |
| | C-4 | Parts by mass | 445 | 445 | | | | 630 |
| | C-5 | Parts by mass | | | | | | |
| | C-6 | Parts by mass | | | 445 | | | |
| | C-7 | Parts by mass | | | | | | |
| | C-8 | Parts by mass | | | | | | |
| | C-9 | Parts by mass | | | | | | |
| | C-10 | Parts by mass | | | | | | |
| | C-11 | Parts by mass | | | | | | |
| | C-12 | Parts by mass | | | | | | |
| | C-13 | Parts by mass | | | | | | |
| | C-14 | Parts by mass | | | | | | |
| | C-15 | Parts by mass | | | | 445 | 445 | |
| | C-16 | Parts by mass | | | | | | |
| | C-17 | Parts by mass | | | | | | |
| Curing agent | GPH-103 | Parts by mass | | 90 | 90 | 90 | 90 | 90 |
| | TD-2090-60M | Parts by mass | 90 | | | | | |
| | HPC-8000-65-T | Parts by mass | | | | | | |
| Phenoxy resin | YX6954BH30 | Parts by mass | 9.9 | 9.9 | 9.9 | 9.9 | 9.9 | 9.9 |
| Curing accelerator | DMAP | Parts by mass | 0.8 | 0.8 | 0.8 | 0.8 | 0.8 | 0.8 |

(continued)

| | | Example 72 | Example 73 | Example 74 | Example 75 | Example 76 | Example 77 |
|---|---|---|---|---|---|---|---|
| Total | Parts by mass | 1385.8 | 1385.8 | 1385.8 | 1385.8 | 1385.8 | 1880.8 |
| Epoxy resin (A) | Parts by mass | 100 | 100 | 100 | 100 | 100 | 100 |
| Sum of filler (B) + filler (C) | Parts by mass | 1185 | 1185 | 1185 | 1185 | 1185 | 1680 |
| Ratio of total surface areas of fillers (S2/S1) | - | 1.35 | 1.40 | 1.40 | 1.50 | 1.50 | 1.35 |
| Thermal conductivity | W/m·K | 6.05 | 6.04 | 5.92 | 3.83 | 3.79 | 3.87 |
| Relative density | - | 0.924 | 0.971 | 0.922 | 0.881 | 0.935 | 0.824 |
| Minimum melt viscosity | poise | 6,520 | 8,530 | 11,050 | 8,320 | 9,050 | 18,730 |
| Linear expansion coefficient | ppm/°C | 19.4 | 19.7 | 19.4 | 20.0 | 20.2 | 17.4 |

[Table 15]

Table 15

| | | | Comparative Example 8 | Comparative Example 9 | Comparative Example 10 | Comparative Example 11 | Comparative Example 12 | Comparative Example 13 |
|---|---|---|---|---|---|---|---|---|
| Solid epoxy resin (A-1) | EPPN-501HY | Parts by mass | 50 | 50 | 50 | 50 | 50 | 50 |
| | NC-3000 | Parts by mass | | | | | | |
| | HP-4700 | Parts by mass | | | | | | |
| Liquid epoxy resin (A-2) | jER-828 | Parts by mass | 50 | 50 | 50 | 50 | 50 | 50 |
| | YDF-8170C | Parts by mass | | | | | | |
| Aluminum nitride filler (B) | B-1 | Parts by mass | | | | | | |
| | B-2 | Parts by mass | 400 | | 740 | 2050 | 600 | |
| | B-3 | Parts by mass | | | | | | |
| | B-4 | Parts by mass | | | | | | 400 |
| | B-5 | Parts by mass | | | | | | |
| | B-6 | Parts by mass | | | | | | |
| | B-7 | Parts by mass | | | | | | |
| | B-8 | Parts by mass | | | | | | |
| | B-9 | Parts by mass | | | | | | |

EP 4 711 416 A1

68

(continued)

| | | | Comparative Example 8 | Comparative Example 9 | Comparative Example 10 | Comparative Example 11 | Comparative Example 12 | Comparative Example 13 |
|---|---|---|---|---|---|---|---|---|
| | B-10 | Parts by mass | | 740 | | | | |
| Alumina filler (C) | C-1 | Parts by mass | | | | | | |
| | C-2 | Parts by mass | | | | | | |
| | C-3 | Parts by mass | | | | | | |
| | C-4 | Parts by mass | 240 | 445 | | | | 240 |
| | C-5 | Parts by mass | | | | | | |
| | C-6 | Parts by mass | | | | | | |
| | C-7 | Parts by mass | | | | | | |
| | C-8 | Parts by mass | | | | | | |
| | C-9 | Parts by mass | | | | | | |
| | C-10 | Parts by mass | | | | | | |
| | C-11 | Parts by mass | | | | 230 | 150 | |
| | C-12 | Parts by mass | | | | | | |
| | C-13 | Parts by mass | | | | | | |
| | C-14 | Parts by mass | | | | | | |

(continued)

| | | | Comparative Example 8 | Comparative Example 9 | Comparative Example 10 | Comparative Example 11 | Comparative Example 12 | Comparative Example 13 |
|---|---|---|---|---|---|---|---|---|
| | C-15 | Parts by mass | | | | | | |
| | C-16 | Parts by mass | | | | | | |
| | C-17 | Parts by mass | | | 445 | | | |
| | GPH-103 | Parts by mass | 90 | 90 | 90 | 90 | 90 | 90 |
| Curing agent | TD-2090-60M | Parts by mass | | | | | | |
| | HPC-8000-65T | Parts by mass | | | | | | |
| Phenoxy resin | YX6954BH30 | Parts by mass | 10 | 10 | 10 | 10 | 10 | 10 |
| Curing accelerator | DMAP | Parts by mass | 0.8 | 0.8 | 0.8 | 0.8 | 0.8 | 0.8 |
| Total | | Parts by mass | 840.8 | 1385.8 | 1385.8 | 2480.8 | 950.8 | 840.8 |
| Epoxy resin (A) | | Parts by mass | 100 | 100 | 100 | 100 | 100 | 100 |
| Sum of filler (B) + filler (C) | | Parts by mass | 640 | 1185 | 1185 | 2280 | 750 | 640 |
| Ratio of total surface areas of fillers (S2/S1) | | - | 1.45 | 1.58 | 0.30 | 0.30 | 0.67 | 1.35 |
| Thermal conductivity | | W/m·K | 2.98 | 2.87 | 2.41 | 2.92 | 2.21 | 3.62 |
| Relative density | | - | 1.012 | 0.843 | 0.782 | 0.793 | 0.998 | 1.001 |
| Minimum melt viscosity | | poise | 2,350 | 28,070 | 16,710 | 8,620 | 1,030 | 4,240 |
| Linear expansion coefficient | | ppm/°C | 26.7 | 19.7 | 20.4 | 16.2 | 24.6 | 27.2 |

When an untreated alumina filler was used as the alumina filler (C), in particular, in Examples 1 to 4, 6, 8, 10, and 12 to 19 in which the ratio S2/S1 of the total surface area of the aluminum nitride filler to the alumina filler was in the range of 0.5 to 2.2, a resin composition film having a high thermal conductivity was obtained.

When the total amount of the fillers is too small (Comparative Example 1), the melt viscosity decreases, but the thermal conductivity is insufficient, and the linear expansion coefficient also increases. When only the aluminum nitride filler is used without blending the alumina filler (Comparative Examples 3 to 6), the filling property of the filler deteriorates, and therefore the melt viscosity increases, and also the relative density and the thermal conductivity decrease. In a case where no alumina filler is used, or an untreated alumina filler is used as the alumina filler (C), when an aluminum nitride filler having a large maximum particle diameter Dmax is used (Comparative Examples 3, 5, and 7) the melt viscosity increases. In a case where an untreated alumina filler is used as the alumina filler (C), when the average particle diameter of the alumina filler is large (Comparative Example 8), the melt viscosity increases, and also the thermal conductivity decreases.

In a case where the surface-treated aluminum nitride filler that has been subjected to a surface treatment with the silane coupling agent (SCI) having an organic reactive group containing an oxygen atom, a nitrogen atom, or a sulfur atom is used as the aluminum nitride filler (B), and the surface-treated alumina filler that has been subjected to a surface treatment with the silane coupling agent (SC2) having an organic reactive group that contains an oxygen atom, a nitrogen atom, or a sulfur atom, and is different from the organic reactive group of the silane coupling agent (SC1) is used as the alumina filler (C), no appearance defects were observed in the resin composition film even without kneading using a three-roll mill. With such a structure, it can be said that a resin composition having particularly excellent dispersibility of the filler was obtained.

**Claims**

1. A resin composition comprising: an epoxy resin (A); an aluminum nitride filler (B); and an alumina filler (C), wherein

   the aluminum nitride filler (B) and the alumina filler (C) are comprised in a total amount of 800 to 1800 parts by mass with respect to 100 parts by mass of the epoxy resin (A),
   the epoxy resin (A) comprises a solid epoxy resin (A-1) and a liquid epoxy resin (A-2),
   the aluminum nitride filler (B) has an average particle diameter D50 of 0.2 to 3 $\mu$m and a maximum particle diameter Dmax of 5 $\mu$m or less, and
   the alumina filler (C) has an average particle diameter D50 of 0.05 to 1.5 $\mu$m.

2. The resin composition according to claim 1, wherein

   the aluminum nitride filler (B) is a surface-treated aluminum nitride filler that has been subjected to a surface treatment with a silane coupling agent (SC1) having an organic reactive group containing an oxygen atom, a nitrogen atom, or a sulfur atom,
   the alumina filler (C) is a surface-treated alumina filler that has been subjected to a surface treatment with a silane coupling agent (SC2) having an organic reactive group that contains an oxygen atom, a nitrogen atom, or a sulfur atom, and is different from the organic reactive group of the silane coupling agent (SCI), and
   the average particle diameter D50 of the aluminum nitride filler (B) is larger than the average particle diameter D50 of the alumina filler (C).

3. The resin composition according to claim 2, wherein

   the aluminum nitride filler (B) is a surface-treated aluminum nitride filler that has been subjected to a surface treatment with a silane coupling agent (SC1) having an organic reactive group containing a (meth)acrylic group, and
   the alumina filler (C) is a surface-treated alumina filler in which an alumina filler (C0) having a product of an average particle diameter D50 ($\mu$m) and a specific surface area SA ($m^2/g$) of 2.6 or more has been subjected to a surface treatment with a silane coupling agent (SC2) having an organic reactive group that contains an amino group forming a secondary amine structure, and is different from the organic reactive group of the silane coupling agent (SC1).

4. The resin composition according to claim 3, wherein
   a ratio (D50/$L_{104}$) of an average particle diameter D50 ($\mu$m) to a crystallite size $L_{104}$ ($\mu$m) calculated from a half width of a diffraction peak attributed to a (104) plane obtained by X-ray diffractometry in the alumina filler (C0) is 6.0 or more.

5. The resin composition according to claim 3, wherein
a ratio (D90/D10) of a 90% particle diameter D90 to a 10% particle diameter D10 calculated from a volume-based cumulative particle size distribution in the alumina filler (C0) is 2.3 or less.

6. The resin composition according to claim 2, wherein

the aluminum nitride filler (B) is a surface-treated aluminum nitride filler that has been subjected to a surface treatment with a silane coupling agent (SCl) having an organic reactive group containing an epoxy group, and the alumina filler (C) is a surface-treated alumina filler in which an alumina filler (C0) having a product of an average particle diameter D50 ($\mu$m) and a specific surface area SA ($m^2$/g) of less than 2.6 has been subjected to a surface treatment with a silane coupling agent (SC2) having an organic reactive group that contains an amino group forming a secondary amine structure, and is different from the organic reactive group of the silane coupling agent (SC1).

7. The resin composition according to claim 6, wherein
a ratio (D50/$L_{104}$) of an average particle diameter D50 ($\mu$m) to a crystallite size $L_{104}$ ($\mu$m) calculated from a half width of a diffraction peak attributed to a (104) plane obtained by X-ray diffractometry in the alumina filler (C0) is 6.0 or less.

8. The resin composition according to claim 2, wherein
the silane coupling agent (SC2) has an organic reactive group containing a phenylamino group.

9. The resin composition according to claim 1, wherein

the aluminum nitride filler (B) has a specific surface area SA of 0.5 to 10 $m^2$/g, and
the alumina filler (C) has a specific surface area SA of 1 to 50 $m^2$/g.

10. The resin composition according to claim 1, wherein
a ratio (S2/S1) of a total surface area S1 of the aluminum nitride filler (B) to a total surface area S2 of the alumina filler (C) is 0.5 to 2.2.

11. A resin composition film made of the resin composition according to any one of claims 1 to 10.

12. A multilayer printed wiring board comprising the resin composition according to any one of claims 1 to 10 or a cured product thereof.

13. A component-embedded substrate comprising the resin composition according to any one of claims 1 to 10 or a cured product thereof.

## INTERNATIONAL SEARCH REPORT

| International application No. |
|---|
| **PCT/JP2024/013944** |

**A.    CLASSIFICATION OF SUBJECT MATTER**

*C08L 63/00*(2006.01)i; *C08K 3/22*(2006.01)i; *C08K 3/28*(2006.01)i; *C08K 9/06*(2006.01)i; *H05K 1/03*(2006.01)i
FI:    C08L63/00 C; C08K3/22; C08K3/28; C08K9/06; H05K1/03 610L; H05K1/03 610R

According to International Patent Classification (IPC) or to both national classification and IPC

**B.    FIELDS SEARCHED**

Minimum documentation searched (classification system followed by classification symbols)

C08L63/00-63/10; C08K3/00-13/08; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| Y | WO 2023/013441 A1 (TOKUYAMA CORPORATION) 09 February 2023 (2023-02-09) claims, paragraphs [0006], [0037], [0050], [0052]-[0054], [0089]-[0093], [0096], [0097], examples, table 2 | 1-13 |
| Y | JP 2020-73626 A (SHOWA DENKO K.K.) 14 May 2020 (2020-05-14) claims, paragraphs [0019], [0020], [0042], [0044], [0056], [0062], examples, table 2 | 1, 9-13 |
| Y | JP 2017-66336 A (HITACHI CHEMICAL COMPANY, LTD.) 06 April 2017 (2017-04-06) claims, paragraphs [0088], [0094] | 1-13 |
| Y | JP 2019-77758 A (AJINOMOTO CO., INC.) 23 May 2019 (2019-05-23) claims, paragraphs [0044], [0045] | 2-8 |
| A | WO 2023/007894 A1 (SHOWA DENKO K.K.) 02 February 2023 (2023-02-02) claims, examples, table 1 | 1-13 |

☐ Further documents are listed in the continuation of Box C.          ☑ See patent family annex.

| | |
|---|---|
| *     Special categories of cited documents: | "T"   later document published after the international filing date or priority date and not in conflict with the application but cited to understand the principle or theory underlying the invention |
| "A"   document defining the general state of the art which is not considered to be of particular relevance | |
| "D"   document cited by the applicant in the international application | "X"   document of particular relevance; the claimed invention cannot be considered novel or cannot be considered to involve an inventive step when the document is taken alone |
| "E"   earlier application or patent but published on or after the international filing date | |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **12 June 2024** | **25 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

EP 4 711 416 A1

## INTERNATIONAL SEARCH REPORT
### Information on patent family members

International application No.

**PCT/JP2024/013944**

| Patent document cited in search report | | | Publication date (day/month/year) | Patent family member(s) | | | Publication date (day/month/year) |
|---|---|---|---|---|---|---|---|
| WO | 2023/013441 | A1 | 09 February 2023 | TW | 202313815 | A | |
| JP | 2020-73626 | A | 14 May 2020 | US | 2022/0119619 | A1 | |
| | | | | claims, paragraphs [0020], [0021], [0043], [0045], [0057], [0063], examples, table 2 | | | |
| | | | | WO | 2021/020540 | A1 | |
| | | | | CN | 113544214 | A | |
| JP | 2017-66336 | A | 06 April 2017 | (Family: none) | | | |
| JP | 2019-77758 | A | 23 May 2019 | (Family: none) | | | |
| WO | 2023/007894 | A1 | 02 February 2023 | US | 2024/0052225 | A1 | |
| | | | | claims, examples, table 1 | | | |
| | | | | CN | 117279995 | A | |

Form PCT/ISA/210 (patent family annex) (July 2022)

74

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011132507 A
- WO 2014208352 A
- JP 2007055888 A